# EUROPÄISCHE PATENTSCHRIFT

(11) **EP 2 954 340 B1**
(45) Veröffentlichungstag und Bekanntmachung des Hinweises auf die Patenterteilung: **18.03.2020**
(21) Anmeldenummer: 14703614.9
(22) Anmeldetag: 11.02.2014
(51) Int. Cl.: G01R 31/40, H01L 31/02, H02H 3/02, G01R 31/02, H02S 50/10, H02H 7/20, H02H 11/00, H02S 50/00

(54) **SICHERE PHOTOVOLTAIKANLAGE**
SAFE PHOTOVOLTAIC SYSTEM
INSTALLATION PHOTOVOLTAÏQUE

(30) Priorität: 11.02.2013 DE 102013101314
(43) Veröffentlichungstag der Anmeldung: 16.12.2015
(73) Patentinhaber: Phoenix Contact GmbH & Co. KG, 32825 Blomberg (DE)
(72) Erfinder: HÖFT, Wolfgang, 32683 Barntrup (DE)
(74) Vertreter: Blumbach · Zinngrebe Patentanwälte PartG mbB
(86) Internationale Anmeldenummer: PCT/EP2014/052666
(87) Internationale Veröffentlichungsnummer: WO 2014/122327

(56) Entgegenhaltungen:
- WO-A2-2010/078303
- WO-A2-2013/010083
- DE-A1-102010 023 549
- DE-A1-102011 107 365
- US-A1- 2009 207 543

## Beschreibung

### Gebiet der Erfindung

Die Erfindung betrifft ein Verfahren zum Erkennen einer elektrischen Störung in einer Photovoltaikanlage, sowie eine Photovoltaikanlage mit zu zumindest einem seriellen Strang zusammengeschalteten Solarmodulen und einem System zum einzelnen Freischalten der Solarmodule und zum sicheren Wiederanschalten der freigeschalteten Solarmodule an den Strang.

### Hintergrund der Erfindung

Bisher sind Solaranlagen häufig ohne besondere Sicherheitsvorkehrungen ausgestattet. Die bei jedem Solarmodul vorhandene Solaranschlussdose (auch Anschlussbox oder junction box genannt) dient im Wesentlichen zur Aufnahme der mechanischen Anschlüsse der Leiterbänder (auch ribbons genannt) des Solarmoduls sowie deren Bypass-Dioden. Solch einfache Solarmodule liefern Spannung sobald sie beleuchtet werden.

Typischerweise werden die Solarmodule zu so genannten Strängen (auch strings genannt) seriell zusammengeschaltet, um eine hohe Strangspannung zu erreichen. Diese Spannung der zu Strängen verschalteten Solarmodule kann mehrere 100 V betragen, wobei für Großanlagen sogar Arbeitsspannungen von im Bereich von 1000 V oder sogar mehr vorliegen, was eine berührgefährliche Spannung darstellt. Ein Solarkraftwerk umfasst ferner ggf. mehrere parallel geschaltete Stränge.

Während der Montage der Solarmodule und deren elektrischer Verbindung in dem Strang kann es bei entsprechender Beleuchtung demnach zu sehr hohen Spannungen kommen, die einen vorsichtigen Umgang bzw. einen besonderen Berührschutz notwendig machen. Gleiches gilt für die Wartung.

Bei solch einfachen Photovoltaikanlagen befindet sich die erste Möglichkeit die Solargeneratorspannung vom Netz zu trennen am Generatoranschlusskasten. Daher besteht bei Schäden durch Feuer, Wasser, Hagel oder anderen Störungen an den Solarmodulen oder den Strangleitungen bei diesen einfachen Solarmodulen keine Möglichkeit, den Teil der Photovoltaikanlage mit den Solarmodulen und den Strangleitungen spannungsfrei zu schalten.

Die internationale Veröffentlichungsschrift WO 2013/010083 A2 zeigt ein Fehlererkennungssystem für ein Photovoltaik-Array. Es wird in jedem Strang ein Strom oder eine Spannung gemessen und eine Kontrolleinheit ist in der Lage, den ganzen fehlerhaften Strang abzuschalten, sollte der gemessene Strom- oder Spannungswert eine Schwelle verlassen haben.

Die deutsche Veröffentlichungsschrift DE 10 2011 107 365 A1 zeigt ein Photovoltaikmodul mit einer Anschlussdose, wobei die Anschlussdose eine Auswertungseinheit aufweist, die eine Spannung und/oder einen Strom zu erfassen vermag. Dem Photovoltaikmodul ist ein Schalter zugeordnet, und die Auswertungseinheit kann den Schalter betätigen, um das Solarmodul bei einem erfassten Fehler abzuschalten.

Die internationale Veröffentlichungsschrift WO 2010/078303 A2 zeigt ein Sicherheits-Abschaltsystem für ein Array von Solarmodulen oder auch für einzelne Solarmodule.

Es sind Sicherheitseinrichtungen bekannt, welche die einzelnen Solarmodule im Brand- oder Fehlerfall abschalten (z.B. DE 10 2009 024 516 A1). Solche Lösungen sind jedoch zumeist lediglich auf eine einmalige Notfallabschaltung ausgerichtet.

In der DE 10 2011 110 682 ist eine Anschlussdose beschrieben, welche bei Abweichung der zulässigen Parameter vom Betriebszustand in einen Sicherheitszustand umschaltet.

In Weiterentwicklung der in der DE 10 2011 110 682 beschriebenen Erfindung betrifft die vorliegende Erfindung insbesondere das sichere Ab- und Einschalten der Photovoltaikanlage unter der Maßgabe, dass die Photovoltaikanlage zwischen einem "echten Störfall" einerseits und "gewöhnlichem Anlagenbetrieb" andererseits zu unterscheiden vermag.

### Allgemeine Beschreibung der Erfindung

Es ist daher eine Aufgabe der vorliegenden Erfindung, eine Photovoltaikanlage bereit zu stellen, welche hohen Sicherheitsanforderungen genügt, insbesondere welche ein sicheres Ausschalten im Falle eines Störfalles sowie ein kontrolliertes erstmaliges Einschalten nach der Montage oder Wiedereinschalten zum Beispiel nach Störfällen, Wartung oder Sonnenaufgang ermöglicht.

Ein weiterer Aspekt der Aufgabe ist, Störfälle, insbesondere elektrische Störfälle, zu erkennen und diese vom Betriebszustand zu unterscheiden.

Weitere Aufgaben ergeben sich aus der nachfolgenden Beschreibung bzw. den besonderen Vorteilen die mit bestimmten Ausführungsformen erzielt werden.

Die Aufgabe wird durch den Gegenstand der unabhängigen Ansprüche gelöst. Vorteilhafte Ausführungsformen sind Gegenstand der abhängigen Ansprüche.

Das erfindungsgemäße Verfahren zum Erkennen einer elektrischen Störung in einer Photovoltaikanlage, insbesondere eines Stranges der Photovoltaikanlage, ist charakterisiert durch die folgenden Schritte. Zunächst wird ein erster Messwertverlauf einer ersten elektrischen Kenngröße in der Photovoltaikanlage gemessen. Bei der ersten elektrischen Kenngröße handelt es sich insbesondere um eine Anlagenspannung oder eine Strangspannung. Für die Messung steht beispielsweise eine Messeinrichtung bereit, welche an den Strang angeschaltet sein kann.

In einem weiteren Schritt wird der erste Messwertverlauf überprüft. Hierbei werden beispielsweise mehrere Punkte der Messgröße in zeitlicher Hinsicht abgetastet (sog. "sampling"), aus den erhaltenen Messwerten digitale Werte gebildet und diese in zeitlicher Reihenfolge gespeichert. Bevorzugt ist es möglich, lediglich mindestens zwei solcher Messwerte aufzuzeichnen bzw. zu berücksichtigen. Besonders bevorzugt wird die erste elektrische Kenngröße in einem bestimmten zeitlichen Abstand abgetastet ("sample rate") und die erhaltenen Daten abgespeichert. Es bildet sich hieraus ein Messwertverlauf, der die Veränderung der elektrischen Kenngröße über die Zeit abbildet. Vorzugsweise kann der Messwertverlauf über einen Zeitraum von größer 1 Sekunde, besonders bevorzugt größer 9 Sekunden, gespeichert werden. Der Messwertverlauf wird nun, beispielsweise mittels einer Auswerteeinrichtung, hinsichtlich charakteristischer Änderungen der Messwerte überprüft. Beispielsweise ist es der einfachste Betriebsfall, dass eine Strangspannung abgetastet wird und sich diese im Verlaufe eines Tages von nach Sonnenaufgang bis vor Sonnenuntergang im Wesentlichen nicht ändert, also im Wesentlichen konstant bleibt.

Anhand des ersten Messwertverlaufs wird nun in einem weiteren Schritt ein Anlagenzustand erkannt. Hierfür können beispielsweise in einem Vergleichsspeicher vordefinierte Messwertverläufe abgespeichert sein, welche mit dem aktuell gemessenen Messwertverlauf verglichen werden.

Entspricht der gemessene Messwertverlauf beispielsweise im Wesentlichen einem Messwertverlauf, wie er für einen Betriebszustand der Anlage typisch oder charakteristisch ist, so wird der Anlagenzustand als normal erkannt bzw. im Betriebszustand befindlich. Entspricht der gemessene Messwertverlauf dagegen beispielsweise im Wesentlichen einem Messwertverlauf, wie er für einen Fehlerfall der Photovoltaikanlage oder des Stranges typisch oder charakteristisch ist, so wird der Anlagenzustand als Fehlerzustand erkannt.

Der erkannte Anlagenzustand wird schließlich in einem Zustandsspeicher gespeichert, so dass dieser zur Verfügung steht, den aktuellen Zustand der Anlage zu kennzeichnen. Mit anderen Worten kann der Zustandsspeicher nun von weiteren Systemen der Photovoltaikanlage, beispielsweise noch im Weiteren zu erläuternden "intelligenten Solarmodulen", ausgelesen werden, um den Anlagenzustand zu erfahren.

Der Anlagenzustand kann bevorzugt zumindest zwei vordefinierte Zustände einnehmen, nämlich einen Betriebszustand oder einen Fehlerzustand. Der Betriebszustand entspricht dabei jedem Anlagenzustand, der im gewöhnlichen Betrieb aufkommt. Mit anderen Worten kann mit dem vorliegenden Verfahren anhand eines Messwertverlaufs und ggf. dessen Vergleich mit einem gespeicherten, vordefinierten Messwertverlauf identifiziert werden, ob sich die Anlage im Betriebszustand befindet. In vorteilhafter Weise kann nun auch das gewöhnliche nächtliche Abschalten dem Betriebszustand zugeordnet werden und im Zustandsspeicher abgelegt werden. So ist es, beispielsweise im Falle der genannten "intelligenten Solarmodule", möglich, dass diese beim Wiederanfahren am Morgen den Anlagenzustand erfahren und in Ansprechen auf den Anlagenzustand das jeweilige Solarmodul an das Stromnetz anschalten.

Vorzugsweise wird auch ein zweiter Messwertverlauf einer zweiten elektrischen Kenngröße der Photovoltaikanlage, insbesondere des Stranges der Photovoltaikanlage, gemessen. Bei der zweiten elektrischen Kenngröße handelt es sich insbesondere um einen Anlagenstrom oder einen Strangstrom. Hierbei werden der erste und der zweite Messwertverlauf synchron überprüft. Der Anlagenzustand kann nun anhand einer Verknüpfung der Überprüfungsergebnisse des ersten und zweiten Messwertverlaufs erkannt werden. Mit anderen Worten kann beispielsweise anhand des zeitlichen Verlaufs vom Strangspannung und Strangstrom der Anlagenzustand in dem entsprechenden Strang der Anlage erkannt werden und dementsprechend die Zustände Betriebszustand oder Fehlerzustand gesetzt werden.

In einer weiteren Ausführungsform der Erfindung wird der erste Messwertverlauf auf einen Spannungsmindestwert größer als Null angehoben. Bevorzugt liegt der Spannungsmindestwert bei mehr als 20 Volt, besonders bevorzugt zwischen 20 bis 40 Volt. In einer einfachen Ausführungsform kann hierfür beispielsweise ein Netzgerät eine Mindestspannung in den Strang der Photovoltaikanlage einspeisen, so dass eine Mindestspannung in der entsprechenden Größe im Strang anliegt.

Bevorzugt weist die Photovoltaikanlage zumindest einen Wechselrichter zum Herstellen einer Wechselspannung aus der Photovoltaikanlagengleichspannung auf, insbesondere um die von der Photovoltaikanlage abgegebene Leistung in ein öffentliches Netz einzuspeisen. Besonders bevorzugt wird das Überprüfen des Messwertverlaufs unterhalb einer Mindestbetriebsspannung des Wechselrichters durchgeführt. Die Mindestbetriebsspannung des Wechselrichters ist beispielsweise ein in der Photovoltaikanlage oder dem Strang der Photovoltaikanlage anliegender Spannungswert, bei dessen Unterschreitung der Wechselrichter den Betrieb einstellt. Mit anderen Worten schaltet ein Wechselrichter typischerweise ab, sobald eine bestimmte Mindestbetriebsspannung in der Photovoltaikanlage oder dem Strang der Photovoltaikanlage unterschritten ist. Die Mindestbetriebsspannung ist typischerweise eine vom Hersteller des Wechselrichters vordefinierte Größe, die häufig in einem Bereich zwischen 110 und 130 Volt liegt.

Die Startbox kann in einer bevorzugten Ausführungsform in Ansprechen auf den Anlagenzustand ein Freigabesignal an Solarmodule der Photovoltaikanlage ausgeben. Hierzu liest die Startbox den Anlagenzustand aus dem Zustandsspeicher aus und gibt beispielsweise nur dann ein Freigabesignal aus, wenn der Anlagenzustand als Betriebszustand gespeichert ist. Mit anderen Worten gibt die Startbox im Betriebszustand kontinuierlich ein Freigabesignal aus, wohingegen die Startbox im Fehlerzustand kein Freigabesignal ausgibt.

Solarmodulen der Photovoltaikanlage kann ferner eine Sicherheitsschaltung zugeordnet sein, welche in Ansprechen auf den Anlagenzustand das zugeordnete Solarmodul freigibt. Das heißt, das der Sicherheitsschaltung zugeordnete Solarmodul wird insbesondere dann freigegeben, wenn das Freigabesignal erkannt wird, es wird andererseits dann elektrisch freigeschaltet, wenn kein Freigabesignal erkannt wird.

Der Anlagenzustand kann neben dem Betriebszustand und dem Fehlerzustand als dritten vordefinierten Zustand ggf. noch den Sicherheitszustand einnehmen. Beispielsweise bei einer gewöhnlichen Abschaltung in der Dämmerung oder bei allgemeiner Dunkelheit erkennt die Auswerteeinrichtung den gewöhnlichen Messwertverlauf, wie er in einem solchen Fall eintritt, und setzt in den Zustandsspeicher den Zustand Sicherheitszustand. Dies ist insbesondere dann interessant, wenn der die Betriebsspannung in der Solaranlage unter die Mindestbetriebsspannung des Wechselrichters fällt, die Solarmodule prinzipiell aber noch eine, ggf. geringe, Leistung abgeben. Dann können die Solarmodule freigeschaltet werden, da die abgegebene Leistung ohnehin nicht mehr von dem oder den Wechselrichter(n) weiterverarbeitet wird. Von besonderem Vorteil der Erfindung ist es, dass eine gewöhnliche Abschaltung des unter die Mindestbetriebsspannung gefallenen Wechselrichters oder der sich abschaltenden Solarmodule erkannt werden kann und dieser Messwertverlauf nicht zu einem Fehlereintrag im Zustandsspeicher führt. Vielmehr kann die Solaranlage bei einem solchen, dem Normalbetrieb zuzurechnenden Messwertverlauf, beispielsweise am nächsten Morgen regulär den Betrieb wiederaufnehmen. Dies ist vor Allem für den Anlagenbetreiber von Interesse, der eine möglichst geringe Ausfallzeit der Anlage erwartet. Andererseits kann es auch zu einer Erhöhung der Sicherheit führen, wenn die Solarmodule automatisch freigeschaltet werden können, wenn der/die Wechselrichter oder die Solarmodule den Betrieb, beispielsweise abends, regulär einstellen.

Bevorzugt gibt die Startbox auch kein Freigabesignal mehr an die Solarmodule aus, wenn der Anlagenzustand den Zustand Sicherheitszustand eingenommen hat. Mit anderen Worten erkennt die Startbox durch das Auslesen des Zustandsspeichers den Sicherheitszustand, und stellt somit in Ansprechen auf den Anlagenzustand die Ausgabe des Freigabesignals ein.

Ggf. ist eine Differenzierung zwischen Anlagenzustand einerseits und Zustand der Sicherheitsschaltung andererseits zu unterscheiden. Bei der Sicherheitsschaltung hat es sich ganz allgemein als geschickt herausgestellt, nur die Zustände "an" und "aus" - entsprechend Betriebszustand (an) und Sicherheitszustand (aus) - bereitzustellen. Den Befehl zum Umschalten bzw. die Information darüber, welcher Zustand von der Sicherheitsschaltung einzunehmen ist, wird wiederum in vorteilhafter Weise von der Starterschaltung bereitgestellt, die bevorzugt unter Berücksichtigung des Anlagenzustands entweder den Startstrom bzw. das Startsignal bereitstellt oder nicht. Die Starterschaltung stellt den Startstrom bzw. das Startsignal besonders bevorzugt nur im Betriebszustand bereit, nicht jedoch im Fehlerzustand oder im Sicherheitszustand der Anlage. Um es noch einmal klar zu beschreiben: die Sicherheitsschaltung benötigt in der beschriebenen Weise nicht den Zustand "Fehlerzustand", sondern nur Betriebs- und Sicherheitszustand. In dieser Ausführungsform ist es aber von Vorteil, wenn die Starterschaltung alle drei Zustände - Betriebszustand, Sicherheitszustand und Fehlerzustand - unterscheidet und diese wie bereits beschrieben verarbeitet. Der Unterschied zwischen Sicherheitszustand und Fehlerzustand ist dann in einem ganz einfachen Fall der, dass die Starterschaltung vom Sicherheitszustand kommend das Wiederanfahren der Solaranlage bzw. das Wiederanschalten der Solarmodule bei Eintritt der entsprechenden Bedingungen (bspw. vorhandenes Sonnenlicht) erlaubt und das Startsignal bzw. den Startstrom aussendet, im Fehlerzustand jedoch nicht und damit im Fehlerzustand die Solaranlage im Wesentlichen stromlos bzw. spannungslos verbleibt, auch wenn die Solaranlage prinzipiell Leistung abgeben könnte. Die Tatsache, dass die Sicherheitsschaltungen in dieser Ausführungsform nur beim Erkennen des Startsignals bzw. des Startstroms die Solaranlage bzw. die Solarmodule für die Leistungsabgabe freigeben, führt zu einer Erhöhung der Anlagensicherheit und kann ggf. auch als "failsafe"-Prinzip beschrieben werden.

Der Zustandsspeicher kann eine Schreibsperre aufweisen, so dass der Zustandsspeicher nicht mehr beschrieben werden kann, sobald der Fehlerzustand im Zustandsspeicher gespeichert ist. Mit anderen Worten können die Anlagenzustände Betriebszustand und Sicherheitszustand nicht mehr geschrieben werden, sobald der Anlagenzustand Fehlerzustand in dem Zustandsspeicher gespeichert ist. Hierdurch ist gewährleistet, dass der einmal erkannte Fehlerzustand nicht im normalen Betrieb überschrieben wird, sobald der Messwertverlauf beispielsweise zufällig wieder die Charakteristik des Betriebszustands einnimmt. Vielmehr verbleibt die Solaranlage oder der Strang im Fehlerbetrieb, in welchem die Solaranlage oder der Strang spannungsfrei geschaltet ist, solange bis der Zustandsspeicher insbesondere durch Fachpersonal zurückgesetzt bzw. gelöscht wurde.

Eine erfindungsgemäße Photovoltaikanlage weist zumindest einen Strang aus seriell zusammengeschalteten Solarmodulen zum Erzeugen von elektrischer Leistung aus Sonnenenergie auf. Selbstverständlich können auch mehrere Stränge vorhanden und parallel geschaltet sein. Die Mehrzahl von Solarmodulen umfassen jeweils eine Solaranschlussdose (auch (Solar-)Anschlussbox oder junction box genannt), mit welcher die Solarmodule an den Strang elektrisch verbunden sind.

Die Solaranschlussdose ist an dem zugehörigen Solarmodul, typischerweise auf der Rückseite des zugehörigen Solarmoduls, befestigt, z.B. aufgeklebt und umfasst eingangsseitige Plus- und Minus-Anschlusselemente, typischerweise in Form von Kontaktklemmen, mit welchen die aus der Oberfläche des Solarmoduls heraustretenden spannungsführenden Leiterbänder (auch ribbons genannt) des Pluspols bzw. Minuspols des zugehörigen Solarmoduls in der Solaranschlussdose angeschlossen bzw. kontaktiert sind. Die Solaranschlussdosen dienen als Verbinder zwischen den Strangleitungen und den spannungsführenden Leiterbändern des zugehörigen Solarmoduls. Die Solaranschlussdosen weisen daher ferner ausgangsseitige Plus- und Minus-Anschlusselemente auf, die im Inneren der Solaranschlussdose mit dem jeweiligen eingangsseitigen Anschlusselement elektrisch verbunden sind. Die Strangleitung besteht aus Verbindungskabeln, welche die Solarmodule des Strangs seriell miteinander verbinden und sind hierzu an die Plus- und Minus-Anschlusselemente der Solaranschlussdosen angeschlossen. Je nach Ausführung werden die Verbindungskabel innerhalb der Solaranschlussdosen kontaktiert oder die ausgangsseitigen Plus- und Minus-Anschlusselemente sind als Steckverbinder ausgebildet und die Verbindungskabel weisen hierzu paarbare Steckverbinder auf, so dass die Verbindungskabel vor Ort an die Solaranschlussdosen angesteckt werden können. Demnach sind die Solarmodule seriell mittels der an die ausgangsseitigen Plus- und Minus-Anschlusselemente angeschlossenen Strangleitung zu dem Strang verbunden. Die Strangleitung bildet hierbei einen Stromkreis aus den seriell zusammengeschalteten Solarmodulen und einem Wechselrichter.

Die Photovoltaikanlage weist ferner eine Messeinrichtung zum Messen eines ersten Messwertverlaufs einer ersten elektrischen Kenngröße in der Photovoltaikanlage, insbesondere des Stranges, auf. Mit anderen Worten wird eine elektrische Kenngröße mittels der Messeinrichtung gemessen, insbesondere abgetastet und digitalisiert. Zum Messen des Messwertverlaufs weist die Messeinrichtung beispielsweise einen Spannungssensor auf zum Messen einer Anlagenspannung oder einer Strangspannung.

Eine Auswerteeinrichtung ist vorgesehen zum Überprüfen des ersten Messwertverlaufs und zum Erkennen eines Anlagenzustands anhand des ersten Messwertverlaufs. Mit anderen Worten wird der erste Messwertverlauf beispielsweise mit in dem Vergleichsspeicher hinterlegten, vordefinierten Messwertverläufen verglichen, um aus dem Vergleich des gemessenen Messwertverlaufs mit dem/den vordefinierten, hinterlegten Messwertverlauf/Messwertverläufen den Anlagenzustand zu erkennen. Der Anlagenzustand kann dabei zum Beispiel drei vordefinierte Zustände einnehmen, nämlich Betriebszustand, Fehlerzustand und Sicherheitszustand.

Das Ergebnis des Messwertvergleichs bzw. der Überprüfung des Messwertverlaufs ist der Anlagenzustand, welcher in einem Zustandsspeicher gespeichert wird.

Der Zustandsspeicher kann ein Flash-Speicher sein, der auch bei Ausfall der Energieversorgung den abgespeicherten Anlagenzustand behält. Dies gibt eine erhöhte Sicherheit im Falle einer elektrischen Störung. Es ist aber auch bevorzugt, dass der Zustandsspeicher von der Solaranlage mit der benötigten elektrischen Leistung versorgt wird. Somit bleibt der Anlagenzustand in diesem Fall auch bei einem normalen Abschalten der Solaranlage bei eintretender Dunkelheit weiterhin gespeichert.

Die Auswerteeinrichtung kann einen Mikrocontroller aufweisen, der Rechenoperationen zur Bestimmung des Anlagenzustands ausführt. Beispielsweise in dem Fall, dass der gemessene, aktuelle Messwertverlauf mit vordefinierten, gespeicherten Messwertverläufen verglichen wird, sind unter Umständen zahlreiche Rechenoperationen durchzuführen, um die sichere Erkennung des Anlagenzustands zu gewährleisten. Bevorzugt ist der Vergleichsspeicher dem Mikrocontroller zugeordnet. In dem Vergleichsspeicher können vordefinierte Messwertverläufe für den Betriebszustand und den Fehlerzustand, ggf. auch für den Sicherheitszustand, hinterlegt sein. Der Mikrocontroller kann dann die gemessenen Messwertverläufe mit den vordefinierten Messwertverläufen vergleichen und daraus, ggf. anhand der Rechenoperationen, den Anlagenzustand erkennen.

Die Messeinrichtung kann ferner hergerichtet sein zum Messen eines zweiten Messwertverlaufs einer zweiten elektrischen Kenngröße der Photovoltaikanlage, insbesondere des Stranges der Photovoltaikanlage. Beispielsweise kann es vorteilhaft sein, zugleich die Strangspannung und den Strangstrom, oder zugleich die Anlagenspannung und den Anlagenstrom, zu messen.

Die Auswerteeinrichtung ist in dieser Ausführungsform ferner hergerichtet zum synchronen Überprüfen des ersten und zweiten Messwertverlaufs und zum Erkennen des Anlagenzustands anhand einer Verknüpfung der Überprüfungsergebnisse des ersten und zweiten Messwertverlaufs. Mit anderen Worten werden sowohl erster als auch zweiter Messwertverlauf überprüft und festgestellt, ob bei beiden Messwertverläufen simultan bestimmte charakteristische Messwertverläufe auftreten, wie sie beispielsweise den vordefinierten, im Vergleichsspeicher hinterlegten Messwertverläufen entsprechen. Durch eine simultane Überprüfung beispielsweise von Strom und Spannung in dem Strang kann die Erkennung des Anlagenzustands noch sicherer gemacht werden, da gewisse Störfälle besser erkannt werden können, wenn sowohl der Spannungsverlauf als auch der Stromverlauf überprüft wird. Somit wird es möglich, den Betriebszustand der Anlage zu erweitern, die Anlagenbetriebszeit über das Jahr zu verlängern und somit den Anlagenertrag zu erhöhen bei gleichzeitiger Erhöhung der Anlagensicherheit.

Der Schreibschutz des Zustandsspeichers kann automatisch aktiviert werden, sobald der Fehlerzustand im Zustandsspeicher gespeichert ist. Mit anderen Worten kann der Eintrag "Fehlerzustand" automatisch einen Schreibschutz aktivieren, der nur durch aktives Entfernen wieder gelöscht werden kann.

Beispielsweise kann der Schreibschutz mittels manueller Betätigung eines Aktivierungsschalters oder ferngesteuertem Starten einer Starterschaltung, durch Senden eines Startsignals an eine Schnittstelle der Starterschaltung zurückgesetzt bzw. gelöscht werden, so dass die Photovoltaikanlage wieder zur Erzeugung elektrischer Leistung bereitsteht. Dieser Vorgang ist ferner bevorzugt nur von eingewiesenem Personal durchführbar, beispielsweise indem entsprechende Sperr- oder Sicherheitsmechanismen eingeführt werden.

An die Strangleitung kann eine Starterschaltung angeschlossen sein, welche den Zustandsspeicher enthaltend den Anlagenzustand ausliest und welche dazu ausgebildet ist, in Ansprechen auf den Anlagenzustand einen Startstrom oder ein Startsignal in die Strangleitung einzuprägen. Mit anderen Worten gibt die Starterschaltung das Freigabesignal an die Solarmodule in Form des Startstroms oder des Startsignals aus. Zumindest einem der Solarmodule ist bevorzugt eine Sicherheitsschaltung zugeordnet, die in Ansprechen auf den Startstrom oder das Startsignal das Abführen des von dem Solarmodul erzeugten Solarstroms durch die Solaranschlussdose über eine Strangleitung freigibt. Mit anderen Worten erkennt die Sicherheitsschaltung des Solarmoduls das Freigabesignal und gibt daraufhin das Solarmodul frei zum Abführen der elektrischen Leistung von dem Solarmodul. In Ansprechen auf das Fehlen des in die Strangleitung eingeprägten Startstrom oder des Startsignals schaltet die Sicherheitsschaltung bevorzugt das Solarmodul von der Photovoltaikanlage frei. D.h., die Sicherheitsschaltung trennt das Solarmodul von der Strangleitung, man kann auch sagen, sie isoliert das Solarmodul. Somit können sich die Einzelmodulspannungen nicht mehr zu einer Strangspannung aufaddieren und gefährlich hohe Spannungen können verhindert werden.

In dem Betriebszustand wird also der von dem zugehörigen Solarmodul erzeugte Solarstrom durch die Solaranschlussdose über die ausgangsseitigen Anschlusselemente und die Strangleitung an den Wechselrichter und damit an das Stromnetz abgeführt. In dem Sicherheitszustand oder dem Fehlerzustand ist das zugehörige Solarmodul in Bezug auf die angeschlossene Strangleitung mittels der Sicherheitsschaltung (spannungs-)freigeschaltet.

Ein Solarmodul mit einer solchen Sicherheitsschaltung wird hierin auch als "intelligentes Solarmodul" bezeichnet. Idealerweise sind alle oder zumindest fast alle Solarmodule intelligente Solarmodule, damit alle oder fast alle Solarmodule des Strangs einzeln freigeschaltet werden können, was die Sicherheit beim ersten Aufbauen der Photovoltaikanlage, beim Warten, beim Reparieren oder einem Störfall wie einem Brand gewährleistet, da allenfalls nur noch wenige bis keine der Solarmodule in einem solchen Fall Spannung an die Strangleitung anlegen. Es kann sogar vorgesehen sein, dass die intelligenten Solarmodule bei Abschattung oder nachts freischalten.

Nun müssen die Solarmodule nach einer derartigen Freischaltung aber auch wieder eingeschaltet bzw. an den Strang angeschaltet werden. Hierzu kann eine an die Strangleitung angeschlossene Starterschaltung umfasst sein, welche dazu ausgebildet ist, einen Startstrom oder ein Startsignal in die Strangleitung einzuprägen. Die intelligenten Solarmodule schließen in dem Sicherheitszustand trotz freigeschalteter Solarmodule den Stromkreis des Strangs, vorzugsweise durch Kurzschlussschalter die im Sicherheitszustand die ausgangsseitigen Plus- und Minus-Anschlusselemente kurzschließen. Mit anderen Worten wird im Falle eines freigeschalteten intelligenten Solarmoduls das Solarmodul mittels der Sicherheitsschaltung elektrisch umgangen.

Besonders bevorzugt ist die Auswertungseinrichtung als Erweiterung der Starterschaltung herzustellen. Die Auswertungseinrichtung ist dann Teil der Starterschaltung. Auch die Messeinrichtung ist bevorzugt Teil der Starterschaltung. Die Auswertungseinrichtung kann dann auch gemeinsam mit der - oder als Teil der - Starterschaltung in einer separat von den Solarmodulen an den Strang angeschlossenen Startbox angeordnet sein.

Die Sicherheitsschaltung kann in dem Sicherheitszustand oder in dem Fehlerzustand von dem zugehörigen Solarmodul mit elektrischer Leistung versorgt werden, sofern das zugehörige Solarmodul Leistung liefern kann, es also von Licht beschienen wird. Hierdurch kann also gewährleistet werden, dass die Sicherheitsschaltung von dem Sicherheitszustand oder von dem Fehlerzustand in den Betriebszustand umschalten kann.

Die Auswertungseinrichtung kann eine Spannungsquelle, insbesondere ein nicht-intelligentes Solarmodul oder ein Netzgerät, umfassen, um den Spannungsverlauf auf einen Mindestwert größer als Null anzuheben. Die Spannungsquelle kann derart eingerichtet sein, dass sie immer dann den Spannungswert oder Spannungsverlauf anhebt, wenn dieser unter den Mindestwert fällt. In einem einfachen Beispiel kann es sich um ein Netzgerät handeln, welches an einen Strang der Solaranlage angeschlossen ist und eine Spannung von 30 Volt immer dann bereitstellt, wenn die Strangspannung unter 30 Volt, bevorzugt 20 bis 40 Volt, fällt. Hierdurch wird die Strangspannung also auf einen Mindestwert angehoben. Vorteilhaft an dem Mindestwert ist, dass die Erkennung eines Fehlerfalles hierdurch vereinfacht wird. Beispielsweise bei einem Leitungsbruch im Feld fällt typischerweise die Strangspannung unter die Mindestspannung. Dies passiert ggf. auch mit angeschlossener Spannungsquelle. Das heißt, ein Unterschreiten der Mindestspannung kann unter bestimmten Voraussetzungen als Fehlerfall identifiziert werden.

Die zu einem Solarmodul zugeordnete Sicherheitsschaltung kann einen Stromsensor aufweist, welcher den von der Starterschaltung in die Strangleitung eingeprägten Startstrom misst oder detektiert, um in Ansprechen auf das Messergebnis die Sicherheitsschaltung von dem Sicherheitszustand oder dem Fehlerzustand automatisch in den Betriebszustand umzuschalten und umgekehrt.

Die Sicherheitsschaltung kann ferner derart ausgebildet sein, dass sie bei Abschattung des zugehörigen Solarmoduls oder bei allgemeiner Dunkelheit und dem damit verbundenen Abfall der Modulspannung automatisch von dem Betriebszustand in den Sicherheitszustand schaltet. Die Auswertungseinrichtung kann ferner derart ausgebildet sein, dass sie bei Unterschreiten einer Mindestbetriebsspannung des Wechselrichters, und damit dem regulären Abschalten des Wechselrichters bei großflächiger Abschattung oder allgemeiner Dunkelheit, automatisch von dem Betriebszustand in den Sicherheitszustand schaltet, so dass kein Startstrom oder Startsignal mehr an die Solarmodule geschickt wird.

Die Starterschaltung kann zumindest einen ersten Schalter aufweisen, mittels welchem zum Starten des Strangs ein Stromkreis in dem Strang schließbar ist. Mit anderen Worten kann die Starterschaltung den ganzen Strang, beinhaltend ggf. auch nicht-intelligente Solarmodule, starten, also mit dem Wechselrichter elektrisch verbinden.

Die Starterschaltung kann eine Stromquelle aufweisen, mittels welcher der in die Strangleitung eingeprägte Startstrom oder das Startsignal gespeist wird.

Die Starterschaltung kann auch einen Controller mit einer Schnittstelle und/oder einem externen Aktivierungsschalter umfassen. Der Controller kann in Ansprechen auf ein Aktivierungssignal an der Schnittstelle und/oder in Ansprechen auf die Betätigung des Aktivierungsschalters und/oder in Ansprechen auf das Signal eines Einstrahlungssensors und/oder in Ansprechen auf eine Zeitsteuerung das Einprägen des Startstroms oder Startsignals in die Strangleitung steuern.

Der Controller kann zumindest einen Signalausgang aufweisen, welcher den Sicherheitszustand, den Betriebszustand und/oder einen Fehlerzustand signalisiert.

Erfindungsgemäß ist ferner eine Startbox mit einer Starterschaltung ausgebildet zum Anschließen an die Strangleitung einer Photovoltaikanlage und zum Einprägen des Startstroms oder Startsignals in die Strangleitung in Ansprechen auf den in dem Zustandsspeicher gespeicherten Anlagenzustand, um das Umschalten der Sicherheitsschaltung vom Sicherheitszustand in den Betriebszustand oder den Fehlerzustand zu bewirken und um das Schreiben des Anlagenzustands in den Zustandsspeicher zu bewirken.

Die Sicherheitsschaltungen der intelligenten Solarmodule können dazu ausgebildet sein, in Ansprechen auf den in die Strangleitung eingeprägten Startstrom oder das Startsignal vom Sicherheitszustand in den Betriebszustand umzuschalten, d.h. vorzugsweise den Kurzschlussschalter, der bevorzugt in der jeweiligen Solaranschlussdose untergebracht ist, zu öffnen und/oder das Solarmodul wieder an die Strangleitung anzuschalten, und damit den Strang bzw. die Photovoltaikanlage zu starten. Der eingeprägte Startstrom oder das Startsignal fließt bzw. läuft dabei im Fehlerzustand und ggf. im Sicherheitszustand durch die serielle Strangleitung und die Solaranschlussdosen.

Der Startstrom ist in einem einfachen Beispiel ein Konstantstrom, welcher von der Sicherheitsschaltung der intelligenten Solarmodule gemessen wird und wobei in Ansprechen hierauf die Sicherheitsschaltung vom Fehlerzustand bzw. Sicherheitszustand in den Betriebzustand umschaltet. Der Startstrom kann allerdings auch gepulst sein, also in Form eines oder mehrerer Strompulse ausgebildet sein. Durch Stromhöhe und/oder Pulsform können sogar weitere Informationen an die intelligenten Solaranschlussdosen übermittelt werden, die das Betriebsverhalten der Sicherheitsschaltung beeinflussen. Der Startstrom kann auch höher kodierte Information enthalten, z.B. in einem durch Strompulse kodierten Signal oder es kann eine höhere Kommunikation, z.B. Powerline über den Strang stattfinden, indem entsprechende Startsignale auf die Strangleitung aufmoduliert und damit eingeprägt werden. Es hat sich dabei als besonders vorteilhaft herausgestellt, wenn die Sicherheitsschaltungen bei einem Fehlen des Startstroms oder Startsignals in den Sicherheitszustand umschalten, so dass hierdurch auch im Sinne eines "failsafe"-Prinzips stets die höchstmögliche Sicherheit gewährleistet ist. Mit anderen Worten geben die Sicherheitsschaltungen die intelligenten Solarmodule in vorteilhafter Weise nur dann frei, wenn die Sicherheitsschaltungen den Startstrom bzw. das Startsignal detektieren.

In vorteilhafter Weise stellt die Erfindung somit nicht nur die Möglichkeit einer Einzelabschaltung der Solarmodule vom Strang bereit, sondern auch eine Möglichkeit zum sicheren erstmaligen Anschalten oder Wiederanschalten der einzeln abgeschalteten intelligenten Solarmodule. Weitere Sicherheits- oder Funktionsrelevante Parameter, z.B. Modulspannung, Strangspannung und/oder Modultemperatur können zusätzlich überwacht werden und das Umschalten der Sicherheitsschaltung zwischen dem Sicherheitszustand und dem Betriebszustand ggf. auch in Ansprechen hierauf gesteuert werden.

Mit anderen Worten können die intelligenten Solarmodule nicht nur "ferngesteuert" durch die Starterschaltung aktiviert bzw. deaktiviert werden, sondern die einzelnen intelligenten Solarmodule können sich ggf. auch selbständig aktivieren bzw. deaktivieren, beispielsweise in dem Fall, dass einzelne Module abgeschattet sind oder eine elektrische Störung haben, die nicht den ganzen Strang betrifft. Somit kann der Strang weiter Leistung abgeben, indem die Sicherheitsschaltung das einzelne defekte intelligente Solarmodul vom Strang abkoppelt.

Gemäß einer Ausführungsform ist die Starterschaltung in einer separat an die Strangleitung angeschlossenen Startbox untergebracht und ist insbesondere seriell zu den Solarmodulen an die Strangleitung geschaltet. Die Startbox wird vorzugsweise in der Nähe des Wechselrichters bzw. bei einer Hausanlage im Gebäudeinneren, zugänglich für den Nutzer angeordnet, so dass hiermit die Umschaltvorgänge der intelligenten Solaranschlussdosen bequem initialisiert werden können. Auch erleichtert dies Wartung und Austausch der Starterbox.

Gemäß einer einfachen Ausführungsform umfasst die Starterschaltung einen in Bezug auf die Strangleitung seriellen Schalter, welcher geschlossen wird, um den Stromkreis der Strangleitung unter Einschluss der Starterschaltung zu schließen und das Fließen des Startstroms oder Laufen des Startsignals in dem so geschlossenen Stromkreis der Strangleitung und den Solarmodulen zu bewirken. Der hierdurch geschlossene Stromkreis aus Strangleitung mit Solarmodulen und Starterschaltung ist vorzugsweise parallel zum Wechselrichter, d.h. unter Umgehung des Wechselrichters geschlossen. Mit anderen Worten bildet die Starterschaltung in dem Strang vorzugsweise einen Bypass zum Wechselrichter bzw. die Starterschaltung ist seriell zu den Solarmodulen und im Nebenschluss zu dem Wechselrichter an die Strangleitung geschaltet.

Die Sicherheitsschaltung der intelligenten Solarmodule umfasst vorzugsweise einen parallel zu dem Solarmodul geschalteten Kurzschlussschalter zwischen den ausgangsseitigen Plus- und Minus-Anschlusselementen und einen seriell in den Strang geschalteten Freischalter. Dabei ist der Kurzschlussschalter in dem Sicherheitszustand geschlossen und schließt die ausgangsseitigen Plus- und Minus-Anschlusselemente der Solaranschlussdose miteinander kurz. Der Freischalter ist in dem Sicherheitszustand geöffnet und trennt den Kurzschlussschalter zumindest einseitig von dem Solarmodul. In dem Betriebszustand ist der Kurzschlussschalter geöffnet und der Freischalter geschlossen und ermöglicht so das verlustfreie Abführen der photovoltaisch erzeugten Leistung des Solarmoduls. Die Trennung des Solarmoduls von dem Kurzschlussschalter im Sicherheitszustand gewährleistet, dass die Sicherheitsschaltung auch in dem Sicherheitszustand von dem zugehörigen Solarmodul mit elektrischer Leistung versorgt wird, sofern genug Licht eingestrahlt wird.

Vorzugsweise weist die Solaranschlussdose eine zentrale Bypassschaltung, insbesondere eine zentrale Bypassdiode auf, welche parallel zu dem Kurzschlussschalter geschaltet ist. Die zentrale Bypassschaltung verhindert wie üblich zusätzlich eine Beschädigung des zugehörigen Solarmoduls bei Abschattung.

Insbesondere umfasst die Sicherheitsschaltung eine elektronische Steuereinrichtung, z.B. in Form eines Mikrocontrollers, welcher beispielsweise in der jeweiligen Solaranschlussdose untergebracht sein kann, welcher in Ansprechen auf den in die Strangleitung eingeprägten Startstrom oder das Startsignal die Umschaltung zwischen dem Sicherheitszustand und dem Betriebszustand der Sicherheitsschaltung steuert, d.h. insbesondere den Freischalter und/oder den Kurzschlussschalter steuert, also den Kurzschlussschalter öffnet und/oder den Freischalter schließt, wenn die Sicherheitsschaltung vom Sicherheitszustand in den Betriebszustand schaltet. Der Mikrocontroller wird hierfür nicht nur im Betriebszustand, sondern auch im Sicherheitszustand von dem zugehörigen Solarmodul mit elektrischer Leistung versorgt, um die Schaltvorgänge steuern zu können.

Gemäß einer Ausführungsform weist die Sicherheitsschaltung einen Stromsensor auf, welcher den in die Strangleitung eingeprägten Startstrom misst (im einfachsten Fall detektiert). Die Steuereinrichtung liest den Stromsensor aus, um in Ansprechen auf das Messergebnis die Sicherheitsschaltung von dem Sicherheitszustand automatisch in den Betriebszustand umzuschalten, wobei insbesondere auch hierfür die elektrische Leistung zum Betreiben der Steuereinrichtung von dem zugehörigen freigeschalteten Solarmodul geliefert wird.

Vorzugsweise ist die Sicherheitsschaltung in der Solaranschlussdose beherbergt. Ferner ist die Sicherheitsschaltung vorzugsweise derart ausgebildet, dass sie bei Abschattung des zugehörigen Solarmoduls oder bei allgemeiner Dunkelheit und dem damit verbundenen Abfall der Modulspannung unter einen vordefinierten Schwellenwert automatisch von dem Betriebszustand in den Sicherheitszustand schaltet. Bevorzugt ist der Kurzschlussschalter hierzu als Öffner ausgebildet und im Ruhezustand geschlossen und/oder der Freischalter ist als Schließer ausgebildet ist und im Ruhezustand geöffnet. Damit wird vorteilhafterweise sichergestellt, dass die Sicherheitsschaltung automatisch in den Sicherheitszustand schaltet, wenn z.B. bei eintretender Dunkelheit die von dem zugehörigen Solarmodul gelieferte Leitung nicht mehr zur Versorgung der Steuereinrichtung ausreicht. Mit anderen Worten befinden sich in dem Sicherheitszustand der Kurzschlussschalter und der Freischalter im Ruhezustand und müssen aus dem jeweiligen Ruhezustand mittels der Steuereinrichtung aktiviert werden, um in Ansprechen auf die Aktivierung die Sicherheitsschaltung vom Ruhe-Sicherheitszustand in den Betriebszustand umzuschalten. Demnach ist der Sicherheitszustand der Ruhezustand der Sicherheitsschaltung und für das Umschalten vom Ruhe-Sicherheitszustand in den Betriebszustand ist ein aktiver Einschaltvorgang notwendig. Dies erhöht die Sicherheit der Photovoltaikanlage.

Ferner bevorzugt weist die Solaranschlussdose zumindest eine der folgenden Einrichtungen auf:
- einen ersten Spannungssensor, welcher die Modulspannung des zugehörigen Solarmoduls misst,
- einen zweiten Spannungssensor, welcher die Strangspannung misst,
- einen Temperatursensor welcher die Temperatur des zugehörigen Solarmoduls überwacht,
wobei die Steuereinrichtung den ersten Spannungssensor und/oder den zweiten Spannungssensor und/oder den Temperatursensor ausliest und in Ansprechen hierauf die Sicherheitsschaltung steuert. Insbesondere schaltet die Sicherheitsschaltung automatisch in den Sicherheitsmodus um, wenn einer oder mehrere dieser Werte außerhalb vorgegebener Intervallgrenzen liegen. Z.B. stellt der Wechselrichter im Normalbetrieb Strom und Spannung auf den Punkt maximaler Leistung (auch "Maximum Power Point" oder "MPP" genannt). Wenn z.B. die von dem Stromsensor und dem ersten und/oder zweiten Spannungssensor gemessenen Werte hiervon abweichen, schaltet die Sicherheitsschaltung automatisch in den Sicherheitszustand. Demnach erfüllt der Stromsensor eine Doppelfunktion, er misst oder detektiert im Sicherheitszustand den eingeprägten Startstrom oder das Startsignal und misst im Betriebszustand den in den Strang eingespeisten Solarstrom.

Gemäß einer Ausführungsform weisen alle Solarmodule eines Strangs eine wie vorstehend definierte Sicherheitsschaltung auf, sind also intelligente Solarmodule. Insbesondere bei dieser Ausführungsform umfasst die Starterschaltung bzw. die Startbox eine eigene Stromquelle zur Erzeugung des Startstroms.

Vorzugsweise ist der Kurzschlussschalter in der Solaranschlussdose von dem Plus- und Minuspol des Solarmoduls aus gesehen vor den ausgangsseitigen Plus- und Minus-Anschlusselementen angeordnet und der Freischalter in der Solaranschlussdose ist seriell zwischen das eingangsseitige Anschlusselement des spannungsführenden Leiters des Pluspols des Solarmoduls und das ausgangsseitige Plus-Anschlusselement oder seriell zwischen das eingangsseitige Anschlusselement des spannungsführenden Leiters des Minuspols des Solarmoduls und das ausgangsseitige Minus-Anschlusselement (bzw. den zugehörigen Anschluss des Kurzschlussschalters) geschaltet.

Der Freischalter ist vorzugsweise seriell zu der zentralen Bypassschaltung und/oder der Kurzschlussschalter ist parallel zu der zentralen Bypassschaltung geschaltet.

Vorzugsweise weist die Solaranschlussdose eingangsseitige Zwischenanschlusselemente für Zwischenabgriffe an dem Solarmodul und mehrere Teilmodul-Bypassschaltungen, insbesondere -dioden zur Kompensation von Teilabschattungen des zugehörigen Solarmoduls auf und die Teilmodul-Bypassschaltungen sind von den Polen des Solarmoduls aus gesehen vor den Freischalter und den Kurzschlussschalter geschaltet, so dass die Teilmodul-Bypassschaltungen auch in dem Sicherheitszustand mit dem Solarmodul verbunden bleiben.

Bevorzugt weist die Starterschaltung eine eigene von den Solarmodulen unabhängige Stromquelle auf und der in die Strangleitung eingeprägte Startstrom oder das Startsignal wird von dieser eigenen Stromquelle gespeist. Die Stromquelle ist z.B. in Form eines Netzteils ausgebildet, und/oder kann in der Startbox integriert sein oder extern an die Startbox angeschlossen werden. Ggf. kann die Stromquelle der Starterschaltung als Energiespeichereinrichtung ausgebildet sein, welche im Normalbetrieb photovoltaisch von dem Strang erzeugte Energie speichert und im Startmodus mit dieser gespeicherten Energie den Startstrom oder das Startsignal speist.

Vorzugsweise weist die Starterschaltung zumindest einen ersten Schalter auf, mittels welchem zum Starten des Strangs ein Stromkreis im Nebenschluss zu dem Wechselrichter in dem Strang geschlossen wird, um das Fließen des Startstroms oder Laufen des Startsignals in dem so geschlossenen Stromkreis der Strangleitung zu bewirken und somit die Sicherheitsschaltungen der Solaranschlussdosen des Strangs vom Sicherheitszustand in den Betriebszustand umzuschalten, d.h. den Strang zu starten.

Ferner vorzugsweise weist die Starterschaltung zumindest einen Freischalter auf, mittels welchem der Wechselrichter zum Starten des Strangs vom Strang freigeschaltet wird.

Zum Einprägen des Startstroms oder Startsignals in die Strangleitung, d.h. zum Starten des Strangs (Startmodus) ist der Freischalter geöffnet und der erste Schalter ist geschlossen, damit der Stromkreis der Strangleitung geschlossen ist. Im Startmodus bildet die Starterschaltung demnach einen Nebenschluss zum (freigeschalteten) Wechselrichter, wobei die Stromquelle für den Startstrom bzw. das Startsignal mit den Solarmodulen einen geschlossenen Stromkreis bilden, um den Startstrom bzw. das Startsignal über diesen Stromkreis in die Strangleitung einzuprägen und damit durch die Solaranschlussdosen durchzuleiten. Daher wird der erste Schalter hier auch als Nebenschlussschalter bezeichnet.

Der Freischalter ist seriell zum Wechselrichter geschaltet, um diesen im Startmodus der Starterschaltung vom Strang freizuschalten. Bei der Ausführungsform der Starterschaltung mit eigener Stromquelle sind der erste Schalter vorzugsweise seriell zur eigenen Stromquelle und/oder der Freischalter parallel zur eigenen Stromquelle geschaltet.

Im Normalbetrieb der Photovoltaikanlage, in welchem sich die Sicherheitsschaltungen im Betriebszustand befinden, ist der Freischalter der Starterschaltung geschlossen und der erste Schalter oder Nebenschlussschalter der Starterschaltung ist geöffnet, damit die Einspeisung der erzeugten Solarleistung nicht beeinträchtigt wird. Mit anderen Worten ist im Normalbetrieb der Photovoltaikanlage der von der Starterschaltung gebildete Nebenschluss zum Wechselrichter geöffnet.

Ferner vorzugsweise umfasst die Starterschaltung einen elektronischen Controller, z.B. Mikrocontroller mit einer elektronischen Schnittstelle (Interface) und/oder einem externen Aktivierungsschalter und der Controller steuert in Ansprechen auf ein Aktivierungssignal an der elektronischen Schnittstelle und/oder in Ansprechen auf die Betätigung des Aktivierungsschalters das Einprägen des Startstroms oder Startsignals in die Strangleitung.

Es ist ferner vorteilhaft, wenn der Controller zumindest einen Signalausgang aufweist, welcher den Sicherheitszustand und/oder einen Fehlerzustand signalisiert, z.B. über eine Leuchtdiode anzeigt. Der Controller kann allerdings auch eine elektronische Schnittstelle aufweisen, welche den Sicherheitszustand und/oder einen Fehlerzustand z.B. an einen zentralen Rechner übermittelt.

Vorzugsweise ist in die Solaranschlussdose zumindest eine Diebstahlschutzeinrichtung, eine Maximum-Powerpoint-Tracking-Steuerungseinrichtung, eine Spannungsüberwachungseinrichtung, eine Stromüberwachungseinrichtung und/oder eine Temperaturüberwachungseinrichtung eingebaut, welche von den Polen des Solarmoduls aus gesehen vor den Freischalter und den Kurzschlussschalter geschaltet sind und die Diebstahlschutzeinrichtung, die Maximum-Powerpoint-Tracking-Steuerungseinrichtung, die Spannungsüberwachungseinrichtung, die Stromüberwachungseinrichtung bzw. die Temperaturüberwachungseinrichtung werden auch in dem Sicherheitszustand von dem zugehörigen Solarmodul mit elektrischer Energie versorgt.

Die Starterschaltung umfasst daher zusammenfassend zumindest die folgenden Bauteile:
- eine erste Messeinrichtung zum Messen eines ersten Messwertverlaufs, insbesondere
   -- einen Spannungssensor zum Messen der Strangspannung und/oder
   -- eine Einrichtung zum Messen der Strangleistung,
- eine Auswerteeinrichtung zum Überprüfen des ersten Messwertverlaufs und zum Erkennen eines Anlagenzustands anhand des ersten Messwertverlaufs,
- einen Zustandsspeicher zum Speichern des Anlagenzustands.

Die Starterschaltung umfasst ferner vorzugsweise zumindest eines der folgenden weiteren Bauteile:
- eine zweite Messeinrichtung zum Messen eines zweiten Messwertverlaufs, insbesondere
   -- einen Stromsensor zum Messen des Strangstroms und/oder
   -- eine Einrichtung zum Messen der Strangleistung,
   -- wobei die Auswerteeinrichtung zum Überprüfen beider Messeinrichtungen hergerichtet ist,
- eine Einrichtung zur Erkennung von Lichtbögen in dem Strang,
- eine Einrichtung zur Diebstahlerkennung in dem Strang,
- eine Schnittstelle zur Ausgabe der entsprechenden Werte oder einer entsprechenden Signalisierung.

Diese Informationen können ebenfalls über das Interface des Controllers z.B. an einen zentralen Computer übermittelt werden.

Eine weitere Ausführungsform sieht vor, dass zumindest ein Solarmodul eines Strangs keine besagte Sicherheitsschaltung aufweist, also dieses Solarmodul nicht im vorstehenden Sinne "intelligent" ist, so dass dieses Solarmodul nicht in einen Sicherheitszustand versetzt wird, sondern dauerhaft an den Strang angeschaltet bleibt. Hierbei kann die von diesem nicht-intelligenten Solarmodul eingespeiste Solarspannung zum Einprägen des Startstroms oder Startsignals in die Strangleitung als Spannungsquelle genutzt werden, um das Umschalten der Sicherheitsschaltungen der anderen Solarmodule vom Sicherheitszustand in den Betriebszustand zu bewirken und um ggf. die um den Spannungsverlauf auf einen Mindestwert größer als Null anzuheben. Es kann also ggf. auch auf das Netzteil der Starterschaltung verzichtet werden. In diesem Fall liefert nämlich z.B. bei Sonnenaufgang das nicht-intelligente Solarmodul Solarstrom in die Strangleitung, wobei die intelligenten Solarmodule noch freigeschaltet sind. Mit diesem Solarstrom können dann die intelligenten freigeschalteten Solarmodule getriggert werden, um vom Sicherheitszustand in den Betriebszustand umzuschalten.

Gegenstand der Erfindung ist ferner die Startbox mit der Starterschaltung, welche zum Anschließen an die Strangleitung einer Photovoltaikanlage und zum Einprägen des Startstroms oder Startsignals in die Strangleitung ausgebildet ist, um das Umschalten der Sicherheitsschaltung vom Fehlerzustand oder dem Sicherheitszustand in den Betriebszustand, oder vom Betriebszustand in den Fehlerzustand oder Sicherheitszustand, zu bewirken.

Ein weiterer Aspekt der Erfindung ist das Verfahren zum sicheren Einschalten des Strangs der seriell geschalteten Solarmodule.

Im Sicherheitszustand schalten die Sicherheitsschaltungen die Solarmodule in Bezug auf die Strangleitung einzeln spannungsfrei. In Ansprechen auf das Einprägen des Startstroms oder Startsignals in die Strangleitung schaltet jede der Sicherheitsschaltungen das jeweils zugehörige Solarmodul an den Strang an, so dass dann die erzeugte Solarleistung über den Strang abgeführt werden kann.

Das Einprägen des Startstroms oder Startsignals wird von einer an den Strang angeschalteten zentralen Startbox gesteuert und zwar in Ansprechen auf:
- Manuelles Betätigen eines Aktivierungsschalters an der Startbox, z.B. durch den Installateur nach der Erstmontage oder nach einer Wartung und/oder
- ferngesteuertes Starten der Starterschaltung durch Senden eines Startsignals an die elektronische Schnittstelle (Interface) des Controllers der Starterschaltung z.B. durch den Installateur nach der Erstmontage oder nach einer Wartung und/oder
- automatisches Starten in Ansprechen auf eine Zeitsteuerung und/oder
- automatisches Starten in Ansprechen auf die Auswertung eines an die Starterschaltung angeschlossenen Einstrahlungssensors, z.B. allmorgendlich nach Sonnenaufgang, wenn die Lichteinstrahlung für die Einspeisung von photovoltaisch erzeugter Leistung der Photovoltaikanlage an das Stromnetz ausreicht.

Wie vorstehend bereits beschrieben wird der in die Strangleitung eingeprägte Startstrom oder das Startsignal gespeist:
- von einer eigenen Stromquelle an der Starterschaltung, z.B. ein internes oder externes Netzteil oder eine Energiespeichereinrichtung und/oder
- einem Solarmodul des Strangs mit einer Solaranschlussdose, z.B. ohne die besagte Sicherheitsschaltung, also einem nicht-intelligenten Solarmodul.

Zum Einprägen des Startstroms oder Startsignals in die Strangleitung, um das Umschalten der Sicherheitsschaltungen vom Sicherheitszustand in den Betriebszustand zu bewirken, werden zumindest einige der folgenden Schritte in der Starterschaltung durchgeführt:
- Schließen des Nebenschlussschalters in der Startbox zum Schließen des Stromkreises des Strangs mit den Solarmodulen und Einprägen des Startstroms oder Startsignals in die Strangleitung,
- Messen der Strangspannung in der Startbox durch die erste Messeinrichtung,
- Trennen der Stromquelle zum Einprägen des Startstroms oder Startsignals vom Strang, insbesondere durch Öffnen des Nebenschlussschalters der Startbox, wenn die Strangspannung einen vordefinierten Schwellenwert überschreitet (der vordefinierte Schwellenwert ist z.B. die Startspannung am Wechselrichter),
- Schließen des Freischalters zum Anschließen des Wechselrichters an den Strang, und/oder
- Aufladen eines Eingangskondensators am Wechselrichter des Strangs bis die Lade-/Entladekurve des Eingangskondensators flach wird.

Im Folgenden wird die Erfindung anhand von Ausführungsbeispielen und unter Bezugnahme auf die Figuren näher erläutert, wobei gleiche und ähnliche Elemente teilweise mit gleichen Bezugszeichen versehen sind und die Merkmale der verschiedenen Ausführungsbeispiele miteinander kombiniert werden können.

### Kurzbeschreibung der Figuren

Es zeigen:
- Fig. 1: eine perspektivische Darstellung einer typischen Solaranschlussdose,
- Fig. 2: ein Blockschaltbild eines Solarmoduls mit intelligenter Solaranschlussdose im Betriebszustand,
- Fig. 3: wie Fig. 2, aber im Sicherheitszustand,
- Fig. 4: ein Blockschaltbild einer Starterschaltung mit eigener Stromquelle im symbolisierten Strang mit einer Mehrzahl von Solarmodulen,
- Fig. 5: ein Blockschaltbild einer Starterschaltung ohne eigene Stromquelle im symbolisierten Strang mit einer Mehrzahl von Solarmodulen,
- Fig. 6: eine Übersichtsdarstellung eines Strangs der Photovoltaikanlage mit einer Mehrzahl von intelligenten Solarmodulen, Wechselrichter und Startbox,
- Fig. 7: wie Fig. 6, mit einer weiteren Ausführungsform einer Startbox,
- Fig. 8: wie Fig. 7, mit einer weiteren Ausführungsform der Startbox und teilweise nicht-intelligenten Solarmodulen,
- Fig. 9: wie Fig. 6 mit einer weiteren Ausführungsform der Startbox und einem Wechselrichter mit Eingangskondensator,
- Fig. 10a: ein vereinfachtes prinzipielles Blockschaltbild für die Verschaltung der Startbox aus Fig. 4 im Betriebszustand der Photovoltaikanlage,
- Fig. 10b: wie Fig. 10a, aber im Startmodus der Startbox,
- Fig. 11: ein Ablaufdiagramm der Steuerung der Sicherheitsschaltung der intelligenten Solarmodule,
- Fig. 12: ein Ablaufdiagramm der Steuerung der Starterschaltung mit Zustandsspeicher
- Fig. 13: ein typisches Spannungs- und Stromverlaufsdiagramm im Falle einer regulären Anlagenabschaltung bei Sonnenuntergang,
- Fig. 14: ein typisches Spannungs- und Stromverlaufsdiagramm im Falle einer regulären Anlagenabschaltung bei Wechselrichtertrennung,
- Fig. 15: ein beispielhaftes Spannungs- und Stromverlaufsdiagramm bei einem Störfall,
- Fig. 16: ein weiteres beispielhaftes Spannungs- und Stromverlaufsdiagramm bei einem Störfall.

### Detaillierte Beschreibung der Erfindung

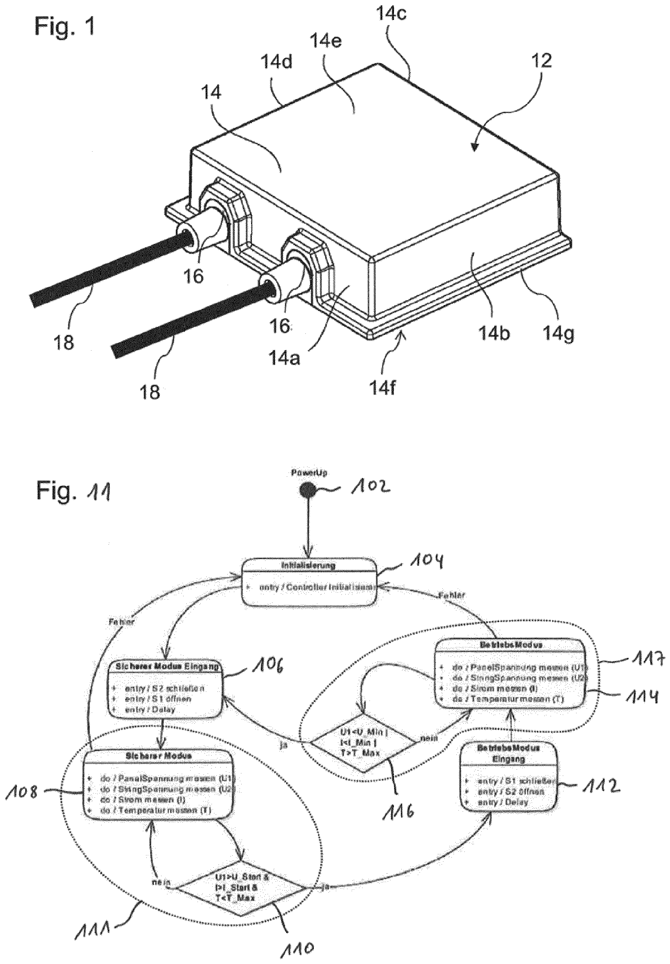

Fig. 1 zeigt eine Solaranschlussdose 12 mit einem Anschlussdosengehäuse 14 zur Montage auf der Rückseite eines Solarmoduls. Das dielektrische Anschlussdosengehäuse 14 ist hutartig ausgebildet und weist umlaufende Seitenwände 14a bis 14d sowie einen Deckel 14e auf. An der in Fig. 1 nicht zu sehenden Unterseite 14f des Anschlussdosengehäuses 14 befinden sich Öffnungen, durch welche die aus dem Solarmodul heraustretenden Leiterbänder in die Solaranschlussdose 12 eintreten, um dort kontaktiert zu werden. Das Anschlussdosengehäuse 14 weist an einer der Seitenwände 14a zwei Kabeldurchführungen 16 auf, durch welche die Strangleitung 18 in die Solaranschlussdose 12 geführt und im Inneren des Anschlussdosengehäuses 14 zum Beispiel mittels nicht dargestellter Kontaktklemmen angeschlossen ist, um die von dem Solarmodul erzeugte elektrische Leistung abzuführen. Ein Rand 14g dient zum Aufkleben der Solaranschlussdose auf dem Solarmodul. Zum grundsätzlichen konstruktiven Aufbau von Solaranschlussdosen wird ferner auf die DE 10 2007 037 130 A1 und die DE 10 2007 042 547 A1 verwiesen.

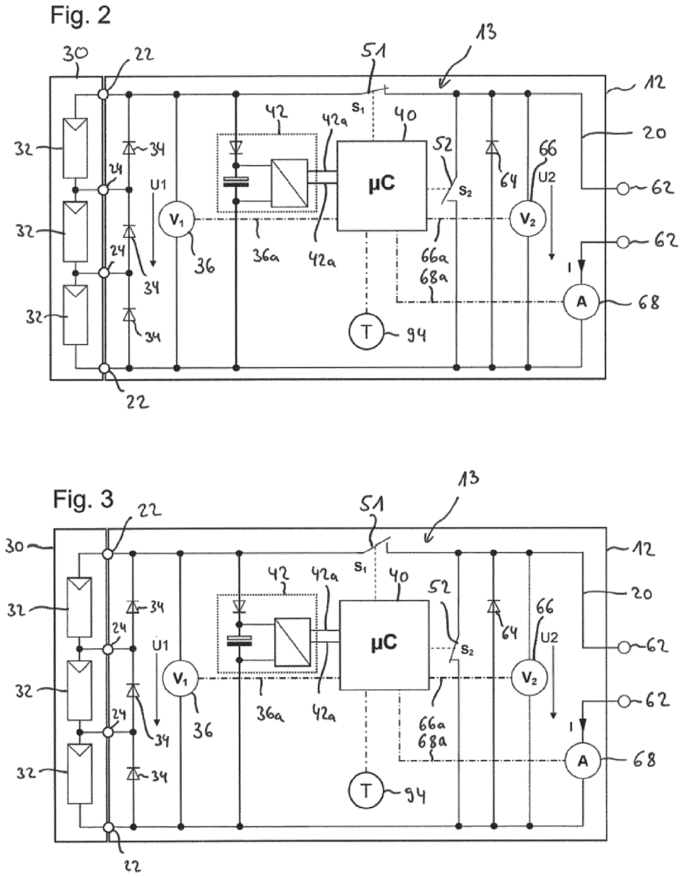

Fig. 2 zeigt ein Blockschaltbild der Solaranschlussdose 12, welche mit eingangsseitigen Plus- und Minus-Anschlusselementen 22 sowie in diesem Beispiel mit zwei Zwischenabgriffen 24 mit den entsprechenden Leiterbändern des Solarmoduls 30 verbunden sind. Parallel zu den Solarzellen oder Solar-Teilmodulen 32 sind Bypass-Dioden 34 geschaltet, um Teilabschattungen des Solarmoduls 30 kompensieren zu können.

Die Solaranschlussdose 12 umfasst eine Sicherheitsschaltung 13, welche die Solaranschlussdose 12 vom Betriebszustand oder Betriebsmodus in den Sicherheitszustand oder Sicherheitsmodus und umgekehrt schalten kann und nachfolgend genauer beschrieben wird.

Ein parallel zu dem Solarmodul 30 geschalteter Spannungssensor 36 (V₁) misst die Modulspannung U1 und wird über die Verbindung 36a von einer Steuereinrichtung in Form eines Mikrocontrollers 40 ausgelesen. Ferner parallel zu dem Solarmodul 30 ist eine Energieversorgungseinrichtung 42 geschaltet, welche den Mikrocontroller 40 über Versorgungsleitungen 42a mit Energie versorgt, damit dieser die Solaranschlussdose 12 steuern kann. Seriell zu dem Solarmodul 30 ist in der Solaranschlussdose 12 ein serieller Freischalter 51 (S1) in dem Strang 20 eingebaut, welcher in dem in Fig. 2 dargestellten Betriebszustand geschlossen ist, um die von dem Solarmodul 30 photovoltaisch erzeugte Leistung über den Strang 20 abzuführen. Ausgangsseitige Plus- und Minus-Anschlusselemente 62 sind mit einem Kurzschlussschalter 52 (S2) in der Solaranschlussdose 12 kurzschließbar, wobei der Kurzschlussschalter 52 in dem Betriebszustand geöffnet ist. Eine zentrale Bypass-Diode 64 zwischen den Plus- und Minus-Anschlusselementen 62 und dem Kurzschlussschalter 52 erzeugt einen weiteren Bypass, zum Beispiel für den Fall einer Fehlfunktion des Kurzschlussschalters 52.

Ein ausgangsseitiger Spannungssensor 66 misst die Strangspannung (U2), unabhängig vom Schaltzustand der Schalter 51 und 52, und wird über die Verbindung 66a von dem Mikrocontroller 40 ausgelesen. Ein Stromsensor 68 misst sowohl den Strangstrom in dem in Fig. 2 dargestellten Betriebszustand, als auch den Startstrom, bzw. detektiert das Startsignal in dem in Fig. 3 dargestellten Sicherheitszustand und wird über die Verbindung 68a von dem Mikrocontroller 40 ausgelesen. Der Mikrocontroller 40 liest den eingangsseitigen Spannungssensor 36, den ausgangsseitigen Spannungssensor 66 und den Stromsensor 68 aus und steuert in Ansprechen auf die Messwerte den Freischalter 51 und den Kurzschlussschalter 52.

Fig. 3 zeigt ein Blockschaltbild der intelligenten Solaranschlussdose 12 in dem Sicherheitszustand. Im Sicherheitszustand ist der Freischalter 51 geöffnet und der Kurzschlussschalter 52 geschlossen, so dass das Solarmodul 30 einerseits von dem Strang 20 getrennt ist und der Strang 20 mittels des Kurzschlussschalters 52 kurzgeschlossen ist. Auch in dem Sicherheitszustand wird die Energieversorgung 42 von dem zugehörigen Solarmodul 30 mit Energie versorgt, sofern das Solarmodul 30 beleuchtet wird. Die Energieversorgung 42 wiederum versorgt den Mikrocontroller 40, so dass dieser auch im Sicherheitszustand in Betrieb bleibt, solange die Einstrahlung ausreicht. Mit anderen Worten kann der Mikrocontroller 40 auch in dem in Fig. 3 dargestellten Sicherheitszustand die ein- und/oder ausgangsseitigen Spannungssensoren 36, 66 und/oder insbesondere den Stromsensor 68 auslesen und/oder die Schalter 51 und/oder 52 steuern. Vorzugsweise ist der Freischalter 51 als Schließer und/oder der Kurzschlussschalter 52 als Öffner ausgebildet, so dass der in Fig. 3 dargestellte Sicherheitszustand dem Ruhezustand der Schalter 51, 52 entspricht. Dies hat den Vorteil, dass spätestens wenn das Solarmodul mangels hinreichender Beleuchtung nicht mehr genug Leistung zum Versorgen des Mikrocontrollers 40 liefert, die "intelligente Solaranschlussdose" 12 (das ist die Solaranschlussdose eines intelligenten Solarmoduls) automatisch in den Sicherheitszustand schaltet.

Wenn sich nun alle Solaranschlussdosen 12 eines Strangs 20 im Sicherheitszustand befinden, bedeutet dies, dass kein photovoltaisch erzeugter Strom fließt und der Sicherheitszustand nicht ohne Weiteres verlassen wird, selbst dann, wenn zum Beispiel die Sonne aufgeht und die Einstrahlung hinreichend stark ist. Ein einfaches Öffnen des Kurzschlussschalters 52 und Schließen des Freischalters 51 würde dazu führen, dass eine berührgefährliche Spannung entstehen kann, wenn dies mehrere Solaranschlussdosen 12 zur selben Zeit machen würden. Daher ist ein dieser Erfindung zugrunde liegendes Problem, sicherzustellen dass der Stromkreis des Strangs 20 geschlossen ist, wenn die Solarmodule photovoltaisch erzeugte Spannung an den Strang anlegen, damit keine so genannte Offenspannung bei nicht geschlossenem Stromkreis an möglicherweise offenen Kontakten anliegen kann.

Hierzu wird nun ein Startstrom oder Startsignal von einer externen Startbox 70 in den auch im Sicherheitszustand der Solaranschlussdosen 12 geschlossenem Stromkreis des Strangs 20 in den Strang eingeprägt.

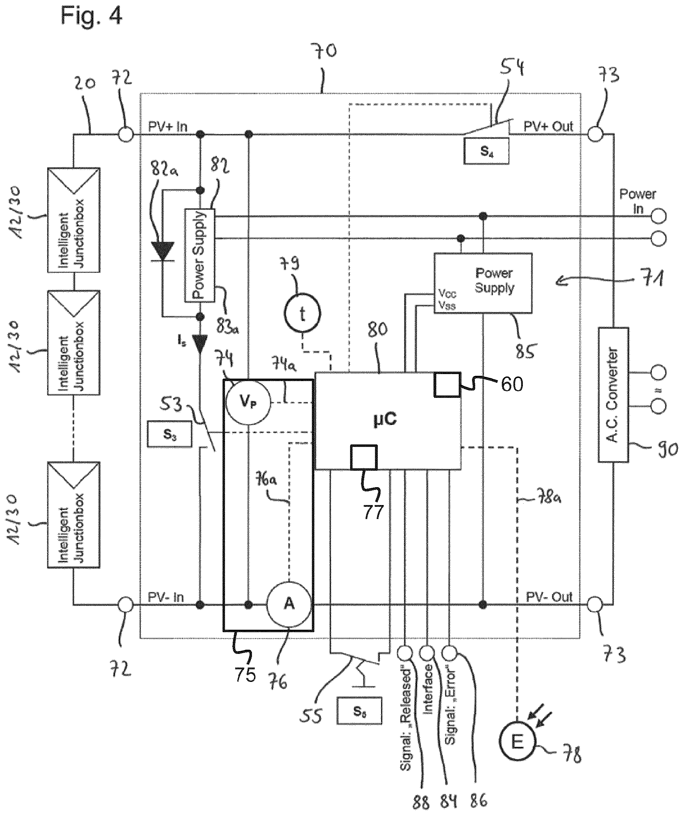

Bezug nehmend auf Fig. 4 ist die Startbox 70 an den Strang 20 mit den Solarmodulen 30 und ihren intelligenten Solaranschlussdosen 12 angeschaltet und befindet sich in dem in Fig. 4 dargestellten Zustand zum Normalbetrieb der Photovoltaikanlage 1. In diesem Beispiel ist die Startbox 70 in beide Leitungen (Plus- und Minus-Leitung) des Strangs - d.h. beidseitig zweipolig - in Reihe zwischen die seriell geschalteten Solarmodule 30 und den Wechselrichter 90 geschaltet. Hierzu ist die Startbox 70 über zwei Eingangsanschlüsse 72 mit dem Solargenerator, bestehend aus den Solarmodulen 30 verbunden und über die zwei Ausgangsanschlüsse 73 ist die Startbox 70 mit dem Wechselrichter verbunden. Ein Spannungssensor 74 (V_{P}) misst die Strangspannung U3. Ein Stromsensor 76 (A) misst den Strom auf dem Strang, welches entweder der photovoltaisch erzeugte Solarstrom im Betriebszustand oder der Startstrom im Sicherheitszustand bzw. Startmodus sein kann. Ein Einstrahlungssensor 78 misst das vorhandene Licht. Ein Controller oder Mikrocontroller 80 ist über Verbindungen 74a, 76a, 78a mit dem Spannungssensor 74, dem Stromsensor 76 bzw. dem Einstrahlungssensor 78 verbunden und liest diese aus, um sowohl die Strangspannung, als auch den Strom auf dem Strang und die Einstrahlung zu überwachen und im Ansprechen auf diese Messwerte die Starterschaltung 71 in der Startbox 70 zu steuern.

Die Starterschaltung weist in diesem Beispiel eine interne Stromquelle 82 auf, zu welcher eine Diode 82a in Durchlassrichtung zum Solarstrom parallel geschaltet ist. Der Mikrocontroller 80 steuert einen, in Bezug auf den Strang 20 mit den Solarmodulen 30, zur Stromquelle 82 parallelen und zum Wechselrichter 90 seriellen Freischalter 54 und/oder einen, in Bezug auf den Strang 20 mit den Solarmodulen 30 und zur Stromquelle 82, seriellen ersten Schalter 53. Die Stromquelle 82 ist in diesem Beispiel als internes Netzteil 83a der Startbox 70 vorgesehen. In dem in Fig. 4 dargestellten Betriebszustand der Photovoltaikanlage 1 ist der Freischalter 54 geschlossen und der zur Stromquelle 82 serielle erste Schalter oder Nebenschlussschalter 53 ist geöffnet, so dass die dargestellte Starterschaltung 71 in diesem Zustand nahezu verlustfrei ist und der photovoltaisch erzeugte Strom nahezu verlustfrei durch die Starterschaltung 71 zum Wechselrichter 90 fließen kann.

Zum Starten des Strangs 20 bzw. der intelligenten Solaranschlussdosen 12 ist der Freischalter 54 geöffnet und der Nebenschlussschalter 53 geschlossen. Nun wird der von der Stromquelle 82 erzeugte Startstrom I_{S} für eine vorbestimmte Zeit t_{S} in den Strang 20 eingeprägt. Die Photovoltaikanlage 1, das heißt die intelligenten Solaranschlussdosen 12 befinden sich hierbei zunächst noch im Sicherheitszustand, so dass einerseits der in den Strang eingeprägte Startstrom oder das Startsignal durch den Strang fließen kann und andererseits in diesem Beispiel kein photovoltaisch erzeugter Strom durch den Strang fließt.

Wenn in Ansprechen hierauf alle intelligenten Solaranschlussdosen 12 aktiviert wurden, d.h. vom Sicherheitszustand in den Betriebszustand umgeschaltet haben, wird der Nebenschlussschalter 53 wieder geöffnet und der Freischalter 54 wird wieder geschlossen, so dass nun der photovoltaisch erzeugte Strom durch den Strang 20 fließen und die entsprechende Photovoltaik-Leistung ins Netz eingespeist werden kann.

Falls das Starten oder die Startsequenz fehlschlägt, kann diese automatisch wiederholt werden, was ebenfalls von dem Mikrocontroller 80 gesteuert wird. Da der Mikrocontroller 80 mit dem Spannungssensor 74 und dem Stromsensor 76 die Strangspannung und den Strangstrom überwacht und auswertet können diese Messwerte zur Berechnung der Strangleistung und zur Steuerung der Schaltvorgänge herangezogen werden.

Mit einem manuellen Aktivierungsschalter 55 (S5) kann der Startvorgang an der Startbox 70 auch manuell initiiert werden, d.h. die Photovoltaikanlage 1 manuell gestartet und vom Sicherheitszustand in den Betriebszustand versetzt werden. Über eine elektronische Schnittstelle 84 des Mikrocontrollers 80 können diese Informationen zum Beispiel mit einem Computer ausgelesen werden. Der Mikrocontroller 80 weist ferner Signaleinrichtungen 86, 88 auf, zum Beispiel in Form von Leuchtdioden, welche an der Startbox 70 einen möglichen Fehlerzustand ("Error/Fehler") bzw. das Vorliegen des Sicherheitszustandes ("Released/frei geschaltet") anzeigen.

Das Starten kann ferner über die Schnittstelle 84 ("Interface") durch eine übergeordnete Steuerung initiiert werden oder der digitale Eingang, an dem der Aktivierungsschalter 55 angeschlossen ist, kann über eine übergeordnete Steuerung geschaltet werden. Mit anderen Worten kann über die Schnittstelle 84 demnach ein Startkommando für das Einprägen des Startstroms bzw. Startsignals gegeben werden.

Im täglichen Normalbetrieb, wird bei Sonnenaufgang der Strang automatisch von der Starterschaltung 71 gestartet, damit der Ertrag der Anlage gesichert ist. Dies kann durch festgelegte Zeitpunkte in Ansprechen auf eine Zeitsteuerung 79 oder durch Auslesen des Einstrahlungssensors 78, die ebenfalls von der Starterschaltung 71 umfasst bzw. an den Mikrocontroller 80 angeschlossen sind, gesteuert bzw. initiiert werden.

Nach Sonnenaufgang werden einerseits die Mikrocontroller 40 der intelligenten Solaranschlussdosen 12 von den zugehörigen Solarmodulen 30 mit Energie versorgt, so dass diese auch in dem zunächst noch vorliegenden Sicherheitszustand energetisch in die Lage versetzt sind, die intelligenten Solaranschlussdosen zu steuern, insbesondere vom Sicherheitszustand in den Betriebszustand umzuschalten.

Zum Starten prägt nun die Starterschaltung 71 bei bereits geöffnetem oder durch Öffnen des Freischalters 54 und durch Schließen des Nebenschlussschalters 53 aus der Stromquelle 82 den Startstrom I_{S} in den Strang 20 ein, welcher von den noch im Sicherheitszustand befindlichen intelligenten Solaranschlussdosen 12 mittels des Stromsensors 68 detektiert und in Ansprechen hierauf steuert der Mikrocontroller 40 die intelligente Solaranschlussdose 12 vom Sicherheitszustand in den Betriebszustand, in diesem Beispiel durch Schließen des Freischalters 51 und Öffnen des Kurzschlussschalters 52. In vorteilhafter Weise ist so sicher gestellt, dass das Initiieren des Startvorgangs in den intelligenten Solaranschlussdosen 12 nur gelingt, wenn der Stromkreis des Strangs 20 auch geschlossen ist, so dass keine gefährliche Offenspannung entstehen kann.

Die Starterschaltung 71 ermöglicht mit den Messgeräten 74 und 76 die Messung von Spannung und Strom des Strangs 20 und die Ausgabe der Werte über die Schnittstelle 84. Aus den Einzelwerten von Spannung und Strom 74, 76 kann die Leistung ermittelt werden und wird ebenfalls über die Schnittstelle 84 zur Verfügung gestellt. Ferner kann mit den Einzelwerten von Spannung und Strom 74, 76 die Funktion überwacht und das Ergebnis ebenfalls über die Schnittstelle 84 zur Verfügung gestellt werden. Ferner ermöglicht die Starterschaltung 71 optional die Erkennung von Lichtbögen in dem Strang 20 (die Lichtbogenerkennung ist nicht dargestellt) und die Ausgabe dieser Werte über die Schnittstelle 84. Die Schaltung 71 ermöglicht ferner die Erkennung von Diebstählen in dem Strang 20 und die Ausgabe des Ergebnisses über die Schnittstelle 84.

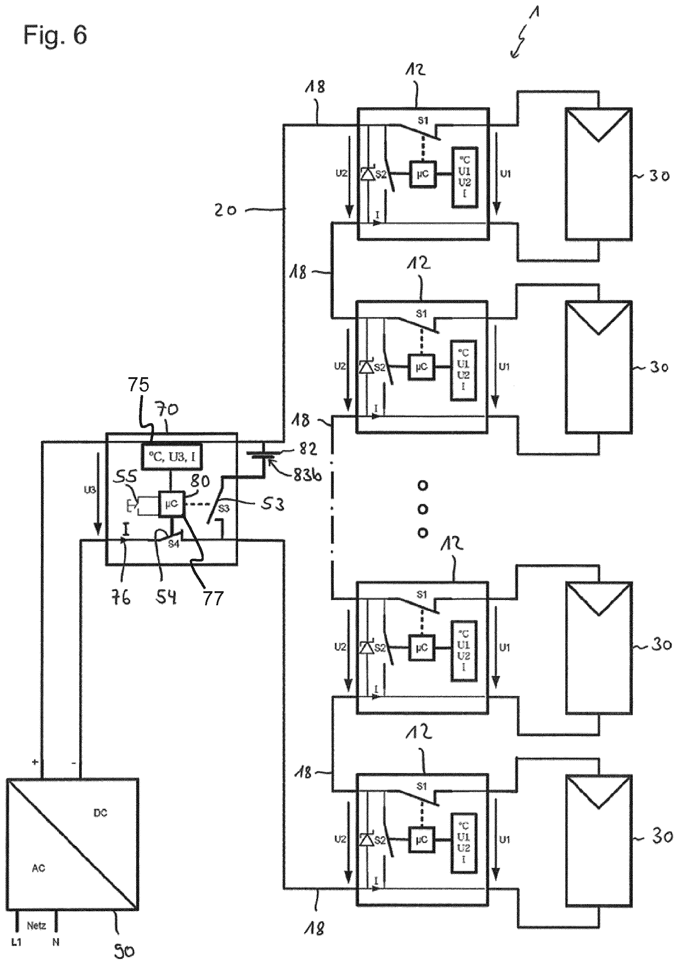

Fig. 6 zeigt ein Beispiel für die Anschaltung der Startbox 70 an den Strang 20 mit einer Mehrzahl von intelligenten Solaranschlussdosen 12. Im Unterschied zu der Startbox 70 in Fig. 4 ist die Stromquelle 82 extern an die Startbox 70 angeschlossen. In Fig. 6 ist der Strang 20 der Photovoltaikanlage 1 im Betriebzustand dargestellt, in welchem die intelligenten Solaranschlussdosen 12 im Betriebszustand sind und die Starterbox 70 inaktiv geschaltet ist, in dem der Nebenschlussschalter 53 (S3) geöffnet und der Freischalter 54 (S4) geschlossen sind.

In diesem Beispiel sind alle Solaranschlussdosen 12 "intelligent", so dass der Strang 20 bei Dunkelheit automatisch vollständig spannungsfrei schaltet oder im Stör- oder Wartungsfall vom Nutzer vollständig spannungsfrei geschaltet wird. Daher erfolgt die Energieversorgung der Starterschaltung 71 bzw. des Startstroms und des Mikrocontrollers 80 z.B. durch den Anschluss an das Versorgungsnetz, in diesem Beispiel durch ein externes Netzteil 83b als Stromquelle 82. Zum Einprägen des Startstroms und damit Starten der Photovoltaikanlage 1 wird der Freischalter 54 (S4) geöffnet und der zur Stromquelle 82 und dem Strang 20 serielle Nebenschlussschalter 53 (S3) geschlossen. Da der zum Strang 20 bzw. zu den Solarmodulen 30 serielle Nebenschlussschalter 53 (S3) zum Wechselrichter parallel geschaltet ist, ist der Stromkreis des Strangs 20 unter Umgehung des Wechselrichters 90 geschlossen, so dass der eingeprägte Startstrom durch den Strang 20 und die Solaranschlussdosen 12 im Sicherheitszustand fließen kann. In den intelligenten Solaranschlussdosen 12 wird der eingeprägte Startstrom gemessen bzw. das Startsignal detektiert und in Ansprechen hierauf werden die intelligenten Solaranschlussdosen 12 von dem jeweiligen Mikrocontroller 40 wieder vom Sicherheitszustand in den dargestellten Betriebszustand umgeschaltet.

Die intelligenten Solaranschlussdosen 12 überwachen in diesem Beispiel (symbolisch dargestellt) Temperatur °C, Modulspannung U1, Strangspannung U2 sowie den Strom I auf den Strang. Die Steuerung der intelligenten Solaranschlussdose 12 erfolgt in Ansprechen auf einen oder mehrere dieser gemessenen Werte. Die Startbox 70 überwacht ebenfalls den Strom I auf dem Strang, Temperatur °C und/oder die Strangspannung U3.

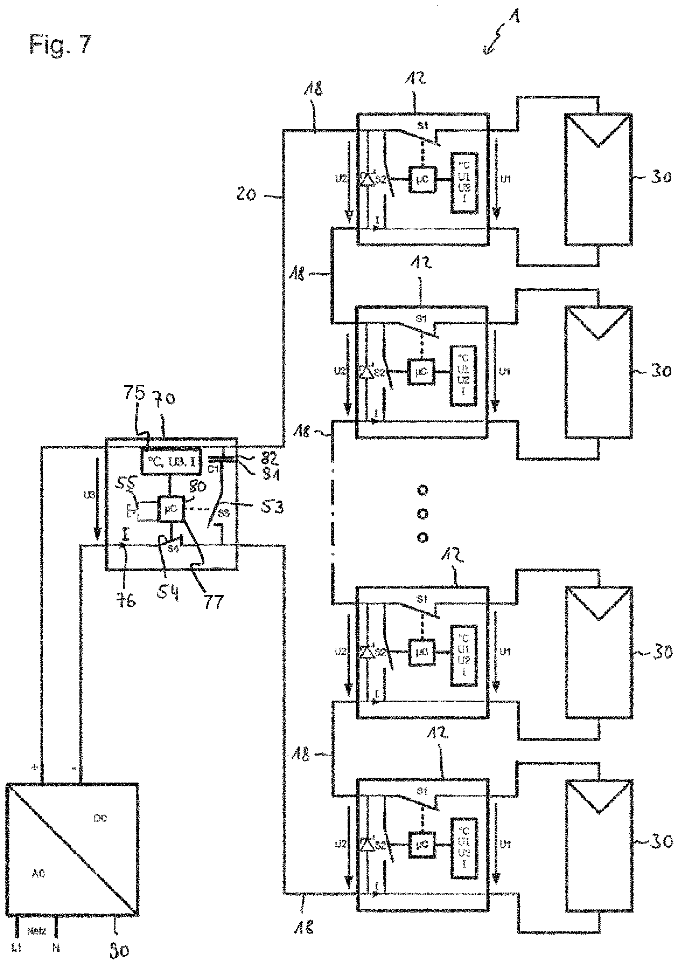

Fig. 7 zeigt den Strang 20 ebenfalls mit ausschließlich intelligenten Solaranschlussdosen 12 und einer geringfügig abgewandelten Ausführungsform der Starterbox 70. Anstatt des externen Netzteils 83b als Stromquelle 82 (Fig. 6) weist die Starterbox 70 in Fig. 7 einen (internen) Kondensator 81 (C1) als Stromquelle 82 auf. Die Sicherheitsschaltungen 13 der intelligenten Solaranschlussdosen 12 bzw. die Photovoltaikanlage 1 werden mittels des Nebenschlussschalters 53 (S3) wie folgt gestartet.

Wenn die Spannung U3 an der Startbox 70 einen unteren Schwellenwert U3ᵤ unterschreitet und/oder wenn der Mikrocontroller 80 ein Startsignal erhält, wird der Nebenschlussschalter 53 (S3) geschlossen und schließt somit den Stromkreis des Strangs 20 durch die intelligenten Solaranschlussdosen 12 und startet dadurch die Sicherheitsschaltungen 13 der intelligenten Solaranschlussdosen 12 und somit die Photovoltaikanlage 1. Bei diesem Starten wird der Nebenschlussschalter 53 (S3) zumindest solange geschlossen, bis die Spannung U3 einen oberen Schwellenwert U3ₒ von z.B. 200 V überschritten hat und wird dann wieder geöffnet. Danach ist die Kapazität 81 (C1) wieder geladen und für den nächsten Start bereit, der dann wiederum erfolgt, wenn die Spannung U3 wieder den unteren Schwellenwert U3ᵤ unterschreitet und/oder der Mikrocontroller erneut ein Startsignal erhält. Im Übrigen arbeitet die Startbox 70 in Fig. 7 wie die Startbox 70 in Fig. 6 mit der konstanten Stromversorgung durch das externe Netzteil 83b, so dass hierauf Bezug genommen werden kann.

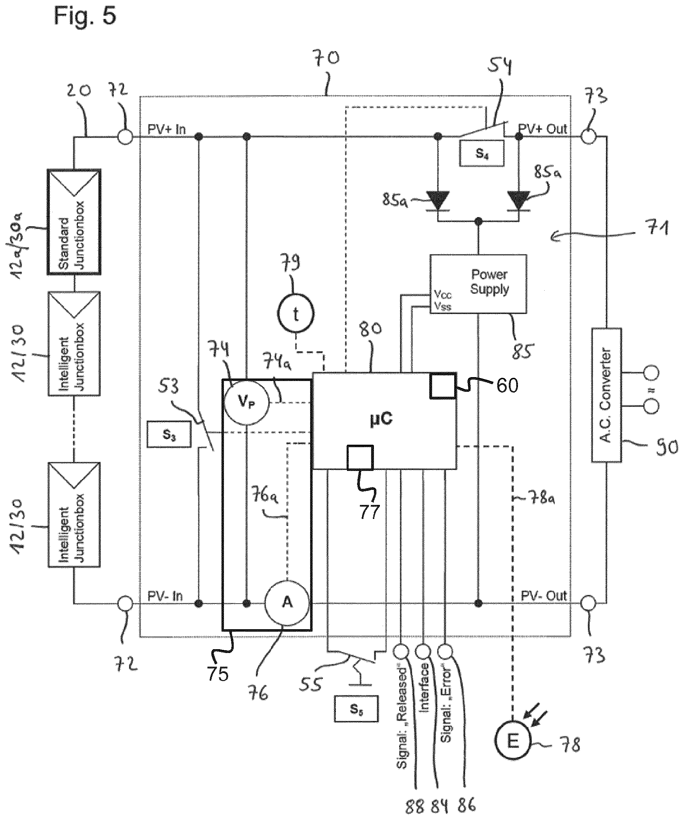

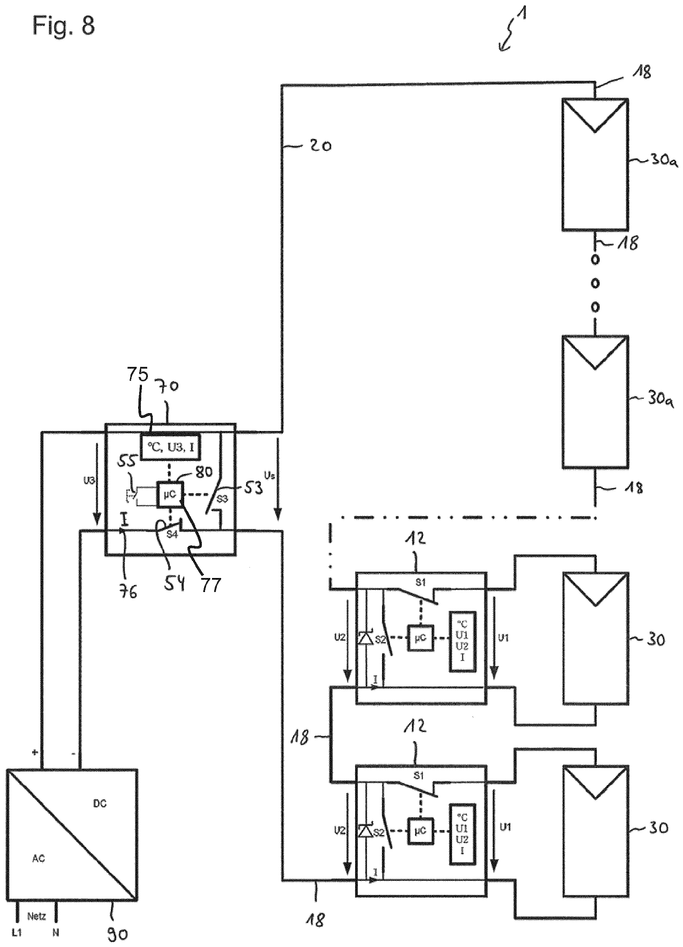

Die Fig. 5 und 8 zeigen eine weitere Ausführungsform des Strangs 20 mit Solarmodulen 30 mit intelligenten Solaranschlussdosen 12 sowie einem oder mehreren weiteren Solarmodule 30a mit einfachen konventionellen ("nicht-intelligenten" - ohne die besagte Sicherheitsschaltung) Solaranschlussdosen 12a, welche der Übersichtlichkeit halber in Fig. 8 nicht dargestellt sind. Mit anderen Worten werden die Solarmodule 30a nicht einzeln an- und abgeschaltet. Die Gesamtspannung der nicht-intelligenten Solarmodule 30a kann unter einer berührgefährlichen Spannung gehalten werden. Nach Sonnenaufgang sind zwar die intelligenten Solarmodule 30 noch vom Strang 20 abgeschaltet, das oder die nicht-intelligenten Solarmodule 30a legen aber ohne Weiteres Spannung an den Strang 20 an.

Allgemein hat also bei dieser Ausführungsform zumindest ein Solarmodul 30a keine intelligente Solaranschlussdose 12 und liefert im normalen Betrieb die notwendige Spannung, den Mikrocontroller 80 der Startbox 70 zu betreiben und den Startstrom für die übrigen intelligenten Solaranschlussdosen 12 des Strangs 20 zu liefern. Daher kann auf ein eigenes Netzteil 83a, 83b der Startbox verzichtet werden. Die Energieversorgung 85 des Mikrocontrollers 80 wird hier über in Durchlassrichtung gepolte Dioden 85a aus der Solarenergie des/der nicht-intelligenten Solarmoduls/e 30a gespeist. Dies spart Kosten bei der Anschaffung, Installation und Wartung.

In dem in den Fig. 5 und 8 dargestellten einfachen Beispiel wird, wenn sich die intelligenten Solaranschlussdosen 12 in dem in Fig. 3 dargestellten Sicherheitszustand befinden, zum Starten des Strangs der zum Strang 20 mit den Solarmodulen 30, 30a serielle Nebenschlussschalter 53 (S3) in der Startbox 70 geschlossen, so dass der Stromkreis des Strangs 20 geschlossen ist und der von den nicht-intelligenten Solarmodulen 30a photovoltaisch erzeugte Strom durch den Strang 20 fließt und den Startstrom bildet. Auch hier schließt also der Nebenschlussschalter 53 im Nebenschluss zu dem Wechselrichter 90 den Stromkreis mit den Solarmodulen 30, 30a, um den Startstrom bzw. das Startsignal in die Strangleitung einzuprägen.

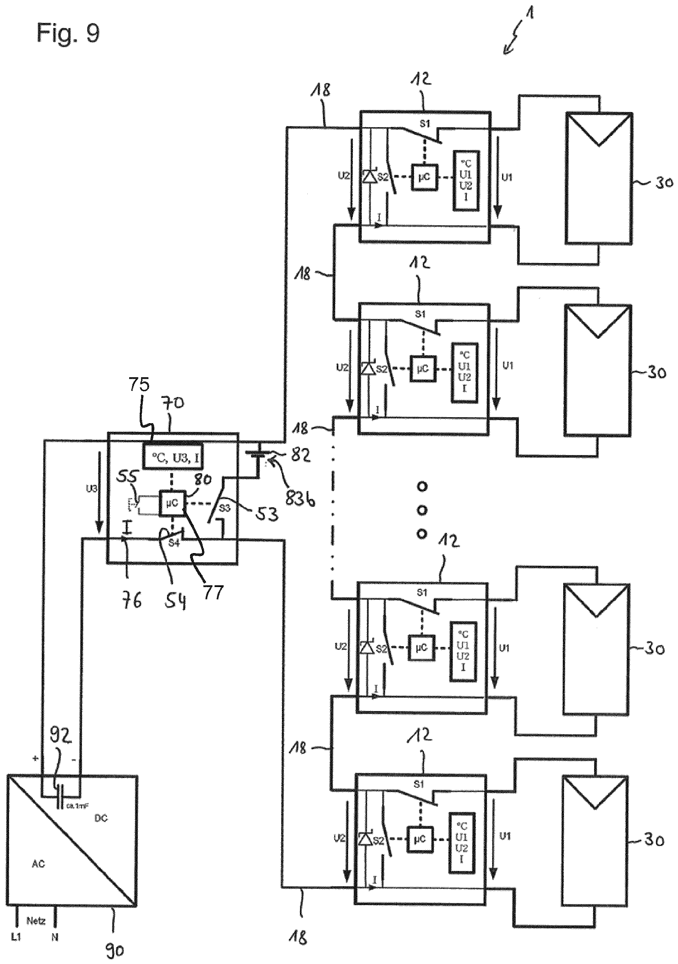

Fig. 9 zeigt eine weitere Ausführungsform des Strangs 20, bei dem der Wechselrichter 90 durch Pulsen aktiviert wird. Der Wechselrichter 90 besitzt eine Eingangskapazität 92 von etwa 1 mF auf der Gleichstromseite. Das Startverhalten des Wechselrichters 90 ist so aufgebaut, dass wenn eine ausreichend hohe Strangspannung zur Verfügung steht, der Wechselrichter 90 eine DC-Netz-Prüfung und anschließend eine solarnetzseitige Belastungsprüfung durchführt. Hierzu wird die Impedanz des Wechselrichters soweit gesenkt, bis sich durch die Belastung die Spannung entsprechend des Arbeitspunktes des Solargenerators auf einen Wert unterhalb der Leerlaufspannung verringert. Wenn nun ein Wert aus dem Produkt von Strom und Spannung entsteht, welcher oberhalb einer Wechselrichter-spezifischen Schwelle liegt, startet der Strang die Produktion von eingespeister photovoltaisch erzeugter Leistung. Dies bedeutet, dass ein hochimpedantes Grundverhalten beim Start des Wechselrichters 90 vorliegt. Ferner benötigt der Wechselrichter 90 eine gewisse Zeit zum Beispiel für eine Erdungsmessung.

Erfindungsgemäß trennt dann die Startbox 70 den Nebenschluss vom PV-Netz bzw. vom Strang 20, wenn eine Strangspannung U3 oberhalb der Schaltschwelle von der Startbox 70 erkannt wird. Am Wechselrichter 90 liegt die Summenspannung der Solarmodule 30 an, die ausreicht, um das Solarkraftwerk zu starten. Wird nun durch eine Fehlfunktion des Wechselrichters 90 der Stromfluss auf dem Strang 20 unterbrochen, kann der Startprozess erneut durchgeführt werden. Dies kann automatisch vom Mikrocontroller 80 der Startbox 70 oder über eine externe Steuerung, zum Beispiel über die Schnittstelle 84 oder den externen Aktivierungsschalter 55 (S5) durchgeführt werden, wobei diese gegebenenfalls mit einer Leitzentrale verbunden sind.

Die Ablaufsequenz bei dieser Ausführungsform läuft wie folgt ab:
1. Die Startbox 70 wird aktiviert, indem der Nebenschlussschalter 53 (S3) geschlossen wird,
2. Der Startstrom Iₖₒₙₛₜₐₙₜ wird aus der Stromquelle 82 (hier: externes Netzteil 83b) in den Strang 20 eingeprägt,
3. wenn die Startspannung am Wechselrichter 90 erreicht ist, wird die Startbox 70 wieder abgeschaltet, indem der Nebenschlussschalter 53 (S3) wieder geöffnet wird,
4. der Freischalter 54 (S4) der Startbox 70 wird getaktet geöffnet und geschlossen und der Kondensator 92 des Wechselrichters wird aufgeladen, bis die Lade-/Entladekurve flach wird (zum Beispiel < 5V/s).

Als Startstrom werden beispielsweise 500mA mit einer Spannung von 24V eingespeist. Wenn die Spannung U3 einen vorbestimmten Schwellenwert übersteigt, z.B. größer als 100V ist, wird der Nebenschlussschalter 53 (S3) geöffnet.

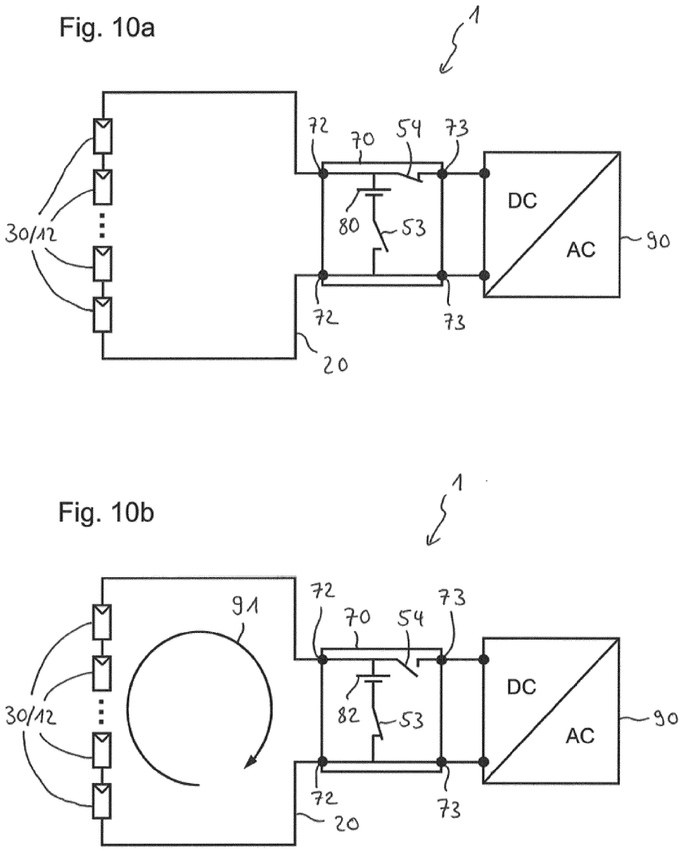

Fig. 10a/b zeigen ein vereinfachtes Blockschaltbild des Strangs 20 mit der Startbox 70 aus Fig. 4. Fig. 10a zeigt den Betriebszustand der Photovoltaikanlage 1 mit geöffnetem Nebenschlussschalter 53 und geschlossenem Freischalter 54. Fig. 10b zeigt die Photovoltaikanlage 1 mit der Startbox 70 im Startmodus, in dem der Nebenschlussschalter 53 geschlossen und der Freischalter 54 geöffnet sind.

Der Nebenschlussschalter 53 ist seriell zu der Stromquelle 82 geschaltet und die Startbox 70 bildet bei geschlossenem Nebenschlussschalter 53 unter Überbrückung des Wechselrichters 90 einen Stromkreis 91 mit den Solarmodulen 30. Demnach bildet die Startbox 70 bei geschlossenem Nebenschlussschalter 53 einen temporären Nebenschluss zu dem mittels dem Freischalter 54 vom Strang freigeschalteten Wechselrichter 90. Mit anderen Worten bildet die Startbox 70 im Startmodus eine Nebenschlussstromquelle (Fig. 10b).

Wenn der Nebenschlussschalter 53 geöffnet ist, ist der durch die Startbox 70 schaltbare Nebenschluss geöffnet und der gewöhnliche Stromkreis für den Betriebszustand der Photovoltaikanlage 1 wird bei geschlossenem Freischalter 54 durch die seriell geschalteten Solarmodule 20 und den Wechselrichter 90 gebildet (Fig. 10a).

Die Schalter 51, 52 (S1, S2) der intelligenten Solaranschlussdosen 12 und/oder die Schalter 53, 54 (S3, S4) der Starterbox 70 können Relais, Halbleiterschalter, insbesondere Feldeffekttransistoren sein.

Fig. 11 zeigt ein Ausführungsbeispiel eines Regelungsalgorithmus der intelligenten Solaranschlussdosen 12. Nach einem "Power-Up" 102 wird der Mikrocontroller 40 in einem Startschritt 104 initialisiert. Anschließend wird in einem Schritt 106 nochmals der Sicherheitszustand sichergestellt, in dem nochmals Eingaben zum Schließen des Kurzschlussschalters 52 und zum Öffnen des Freischalters 51 gemacht werden. Nachfolgend erfolgt eine kurze Verzögerung. In Schritt 108 werden die Modulspannung U1, die Strangspannung U2, der Strom am Sensor 68 und die Temperatur am Temperatursensor 94 gemessen. Ein Prüfschritt 110 prüft ob die Modulspannung U1 einen Schwellenwert U_Start zum Starten überschreitet und ob der Strom am Sensor 68 einen Schwellenwert I_Start überschreitet und ob die Temperatur unterhalb eines bestimmten Schwellenwertes T_Max liegt. Solange nicht alle drei Kriterien erfüllt sind, bleibt die intelligente Solaranschlussdose 12 im Regelkreis 111 des Sicherheitszustandes, welcher von den Schritten 108, 110 gebildet wird.

Wenn die drei Kriterien des Prüfschritts 110 erfüllt sind, schließt der Mikrocontroller 40 den Freischalter 51, öffnet den Kurzschlussschalter 52 und es erfolgt wieder eine gewisse Verzögerung. Im Schritt Betriebsmodus 114 werden wiederum die Modulspannung U1, die Strangspannung U2, der Strangstrom I und die Temperatur T mit den Sensoren 36, 66, 68, 94 gemessen. Im Prüfschritt 116 wird geprüft, ob die Modulspannung U1 unterhalb eines Schwellenwertes U Min oder der Strangstrom I unterhalb eines Schwellenwertes I_Min oder die Modultemperatur T oberhalb eines Schwellenwertes T_Max liegen. Ergibt diese Oder-Verknüpfung ein Nein, bleibt die intelligente Solaranschlussdose 12 im Regelkreis 117 des Betriebszustandes. Der Regelkreis 117 wird von den Schritten 114, 116 gebildet wird. Falls eine der Oder-Verknüpfungen im Schritt 116 zutrifft, folgt wiederum der Schritt 106, also die Einleitung des Sicherheitszustandes. Ferner können im Sicherheitszustand 111 und im Betriebszustand 117 Fehlermeldungen abgegeben werden, die wiederum die Initialisierung 104 auslösen. Im Übrigen ist ersichtlich, dass der Betriebszustand 117 und/oder der Sicherheitszustand 111 aktive Regelkreise umfassen, in welchen die Messwerte, z.B. der eingeprägte Startstrom oder das Startsignal, die Modulspannung U1, die Strangspannung U2 und/oder die Temperatur T abgefragt werden, um die Schaltvorgänge in Ansprechen auf diese Werte auszulösen.

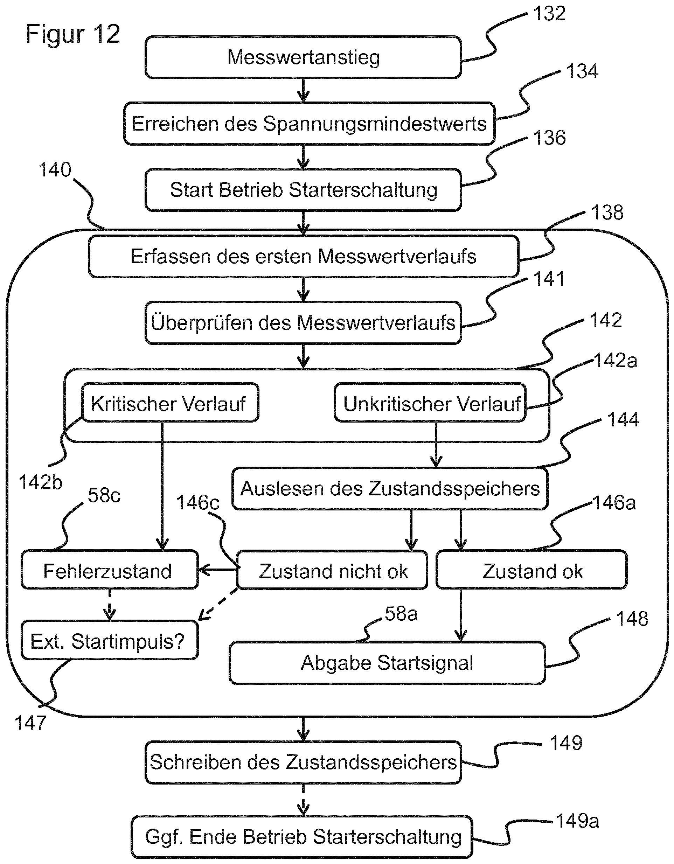

Figur 12 zeigt ein Ausführungsbeispiel eines Regelungsalgorithmus der Starterschaltung 71 mit Messeinrichtung 75 und Auswerteeinrichtung 77. In einem ersten Schritt 132 steigt die Spannung von der Nachtspannung bzw. der Stilllegungsspannung auf einen Spannungsmindestwert 134. Der Spannungsmindestwert 134 wird beispielsweise von der Stromquelle 82, wie dem Netzteil 83a oder 83b oder auch dem nicht-intelligenten Solarmodul 30a bereitgestellt. In dem Fall, dass der Spannungsmindestwert 134 von einem Netzteil 83a, 83b bereitgestellt wird, kann ein Einstrahlungssensor 78 die Information liefern, ob prinzipiell genügend Sonnenlicht für einen Betrieb der Anlage zur Verfügung steht, so dass das Netzteil 83a, 83b nicht auch in der Nacht betrieben wird. Falls ein oder mehrere nicht-intelligente(s) Solarmodul(e) 30a zur Bereitstellung des Spannungsmindestwerts 134 herangezogen werden, so stellen diese die Spannung automatisch zur Verfügung, sobald genügend Licht eingestrahlt wird. Wenn der Spannungsmindestwert 134 an der Starterschaltung anliegt, ist die Starterschaltung mit elektrischer Energie versorgt und startet im Schritt 136 den Betrieb. Die Messeinrichtung 75 erfasst im Schritt 138 die Spannung im Strang 20 bzw. in der Photovoltaikanlage 1 als ersten Messwertverlauf 6. Der erste Messwertverlauf 6 wird mittels der Auswerteeinrichtung 77 im Schritt 141 überprüft und, sofern dieser im Entscheidungsschritt 142 als unkritisch 142a bewertet wird, wird der zuletzt gespeicherte Anlagenzustand 58 im Schritt 144 aus dem Zustandsspeicher 60 gelesen. Wenn als Anlagenzustand 58 ein Zustand abgelegt ist, der den Betrieb der Anlage gestattet (Schritt 146a), also beispielsweise der Betriebszustand 58a oder Sicherheitszustand 58b, beginnt die Starterschaltung 71 im Schritt 148 mit der Aussendung des Startsignals bzw. des Startstroms. Die Solarmodule 30 erkennen das Startsignal bzw. den Startstrom wie bereits mit Bezug zu Figur 11 beschrieben und geben ihre Leistung an den Wechselrichter 90 ab. Die Auswerteeinrichtung 77 vollzieht nun die Regelschleife 140 solange, bis entweder ein kritischer Verlauf 142b des Messwertverlaufs erkannt wird oder eine gewöhnliche Nachtabschaltung stattfindet. Sowohl kritischer Verlauf 142b als auch Nachtabschaltung bzw. jede reguläre Abschaltung führen zu einem Verlassen der Regelschleife 140. Typischerweise führt auch das Erreichen des Spannungsmindestwerts zum Verlassen der Regelschleife 140, wobei die Starterschaltung dazu ausgebildet ist, zwischen verschiedenen erkannten Messwertverläufen zu unterscheiden. Dies wird noch im Weiteren genau erläutert.

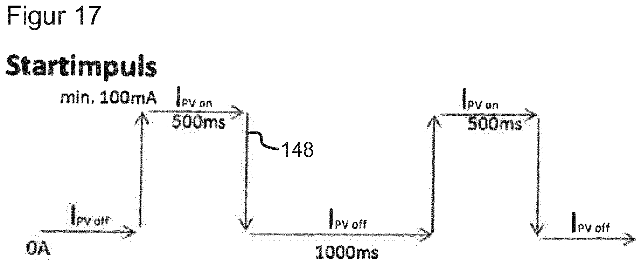

Im Falle, dass der Zustandsspeicher 60 bereits den Fehlerzustand 58c gespeichert hat (Schritt 146c) oder in dem Fall, dass ein kritischer Verlauf 142b zu dem Erkennen des Fehlerzustands 58c führt, ist ein Weiteres durchlaufen der Regelschleife 140 nicht notwendig. Es sind zwei Abbruchvarianten der Regelschleife 140 wählbar bzw. vorteilhaft. Einerseits kann unmittelbar das Schreiben des Zustandsspeichers 149 mit dem Fehlerzustand 58c anschließen. Gegebenenfalls beendet die Starterschaltung hernach den Betrieb mit Schritt 149a. Ein Wiederanschalten der Photovoltaikanlage 1 ist somit nicht ohne Weiteres bzw. nur mit eingewiesenem Personal möglich. Dies ist unter Umständen erwünscht, da Sicherheitsauflagen im Betrieb von Photovoltaikanlagen 1 ggf. das Wiederanschalten nur mit eingewiesenem Personal fordern. Die Einhaltung dieser Vorschrift ist mittels der vorgestellten Starterschaltung 71 ermöglicht. Gegebenenfalls bleibt die Starterschaltung andererseits weiter aktiv und kehrt vor oder nach dem Schritt 149, Schreiben des Zustandsspeichers, zurück in die Regelschleife 140. Anhand des Erfassens des ersten Messwertverlaufs 138 kann ggf. ein externer, von einem Bedienpersonal an die Strangleitung anzulegender externer Startimpuls in Schritt 147 von der Auswerteeinrichtung erfasst und als Wiederanschaltsignal 147 identifiziert werden. Hernach kann die Photovoltaikanlage 1 oder der Strang 20 wieder den Betrieb aufnehmen. Ein Beispiel eines Startimpulses 147 ist in Figur 17 gezeigt.

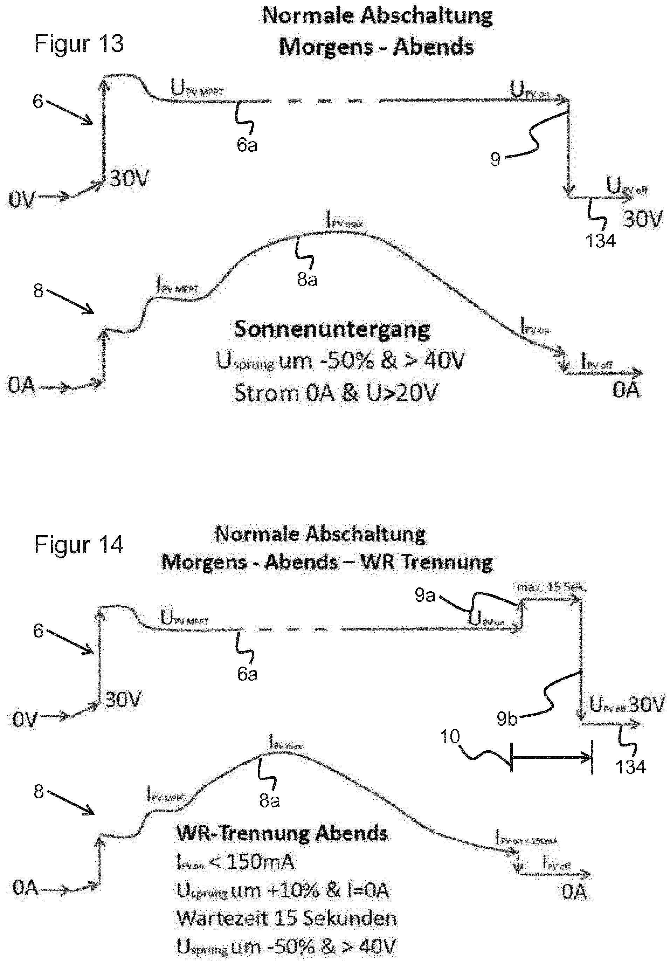

Figur 13 zeigt im oberen Teil einen typischen ersten Messwertverlauf 6, wie er bei einer Messung der Strangspannung oder Anlagenspannung mit einer Messeinrichtung 75, im vorliegenden Fall einem Spannungssensor 74 (vgl. z.B. Figur 5), gemessen werden kann. Vor Inbetriebnahme der Photovoltaikanlage 1 wird ein Messwertanstieg 132 auf einen Mindestwert 134 erkannt. Die Spannung steigt also von der Nachtspannung bzw. der Stilllegungsspannung, in diesem Fall 0 Volt, auf einen Spannungsmindestwert 134, in diesem Fall 30 Volt. Da die meisten Solarmodule 30 intelligente Solarmodule 30 sind, zeigt die Strangspannung auch bei einer Inbetriebnahme mit vorhandener Sonneineinstrahlung an der Stelle des Mindestwerts 134 keinen anderen Verlauf. Obzwar in diesem Fall ggf. kein Anstieg von 0V auf 30V zu beobachten ist, wird die im Strang vorhandene Spannung in einem, insbesondere berührsicheren, Bereich liegen, der weit unterhalb der regulären Betriebsspannung des Stranges 20 bzw. der Photovoltaikanlage 1 liegt.

Der Spannungsmindestwert 134 wird beispielsweise von der Stromquelle 82, wie dem Netzteil 83a oder 83b oder auch dem nicht-intelligenten Solarmodul 30a bereitgestellt. In dem Fall, dass der Spannungsmindestwert 134 von einem Netzteil 83a, 83b bereitgestellt wird, kann ein Einstrahlungssensor 78 die Information liefern, ob prinzipiell genügend Sonnenlicht für einen Betrieb der Anlage zur Verfügung steht, so dass das Netzteil 83a, 83b nicht auch in der Nacht betrieben werde muss. Falls ein oder mehrere nicht-intelligente(s) Solarmodul(e) 30a zur Bereitstellung des Spannungsmindestwerts 134 herangezogen werden, so stellen diese die Spannung automatisch zur Verfügung, sobald genügend Licht eingestrahlt wird. Wenn der Spannungsmindestwert 134 an der Starterschaltung anliegt, ist die Starterschaltung mit elektrischer Energie versorgt und nimmt den Betrieb auf. Wie zuvor beschrieben wird der Messwertverlauf überprüft (Schritt 141, vgl. Fig. 12) sowie der Zustandsspeicher ausgelesen (Schritt 144). Ist der Zustand der Anlage in Ordnung wird das Startsignal an die Solarmodule 30 abgegeben (Schritt 148). Daraufhin schalten die Sicherheitsschaltungen 13 die Solarmodule 30 an, verbinden diese also elektrisch mit dem jeweiligen Strang 20, die Strangspannung oder Anlagenspannung steigt auf die Betriebsspannung 6a. Gegebenenfalls wird die Betriebsspannung 6a mittels des Maximum Power Point Trackers auf die günstigste Spannung zur maximalen Leistungsabgabe eingestellt, wodurch sich die Spannung im Bereich der Betriebsspannung 6a ändern kann. Die Betriebsspannung 6a ist aber in jedem Fall deutlich von dem Spannungsmindestwert entfernt, beispielsweise liegt die Betriebsspannung 6a im Bereich von 1000 V.

Die Betriebsspannung 6a wird von den Solarmodulen 30 bis zum Abschalten der Solarmodule 30 aufrecht erhalten. Beim Abschalten der Solarmodule 30 sinkt die Strang- oder Anlagenspannung wieder auf den Mindestwert, der beispielsweise durch die Stromquelle 82 bereitgestellt wird. Typischerweise bricht beim Abschalten der Solarmodule 30 die Betriebsspannung 6a sprunghaft zusammen, so dass sich im ersten Messwertverlauf 6 eine Sprungstelle 9 bildet.

In einem sehr einfachen Fall gibt die Starterschaltung 71 das Startsignal einfach solange weiter aus, bis die Mindestspannung allmählich unterschritten wird, weil entweder das Netzteil 83a, 83b vermittels des Einstrahlungssensors 78 abgeschaltet wird oder weil das/die nicht-intelligente(n) Solarmodul(e) 30a keine Spannung mehr bereitstellen. Im Zustandsspeicher bleibt der "unkritische" Betriebszustand 58a gespeichert, am nächsten Tag kann die Photovoltaikanlage 1 den Betrieb regulär wieder aufnehmen.

Mit der vorgestellten Starterschaltung 71 ist es jedoch auch möglich, komplexere Messwertverläufe zu Überprüfen, insbesondere auch zwei zeitgleich gemessene Messwertverläufe miteinander in Beziehung zu setzen und daraus zu erkennen, ob der Messwertverlauf einem Fehlerfall oder einem gewöhnlichen Verlauf, wie dem Abschalten bei Sonnenuntergang, entspricht.

In Figur 13 ist im unteren Teil ein zweiter Messwertverlauf 8 dargestellt, der zeitlich gleichzeitig zu dem ersten Messwertverlauf 6 aufgezeichnet wird. Dargestellt ist ein Stromverlauf eines typischen Betriebsstroms 8a. Zum Aufzeichnen des Betriebsstroms 8a wird eine Messeinrichtung 75, im vorliegenden Fall der Stromsensor 76, eingesetzt. Ein Mindeststrom, vergleichbar der Mindestspannung 134, ist nicht vorgesehen. Es ist vorteilhaft, wenn die Stromstärke im Strang 20 oder in der Photovoltaikanlage 1 (je nachdem, ob der Strangstrom oder der Anlagenstrom gemessen wird) unterhalb eines Stromschwellwertes liegt, beispielsweise die Strangstromstärke (oder Anlagenstromstärke) nahe Null liegt bzw. kleiner 150 Milliampere (mA) beträgt.

Der Anlagenstrom bleibt unterhalb des Schwellwertes beim Erreichen des Spannungsmindestwerts (Schritt 134) und bei der Betriebsaufnahme der Starterschaltung (Schritt 136). Erst wenn das Startsignal abgegeben wird (Schritt 148) und die Solarmodule 30 gesteuert durch die Sicherheitsschaltungen 71 den Betrieb aufnehmen, wird eine nennenswerte Stromstärke, der Betriebsstrom 8a, im Strang zum Wechselrichter 90 hin abfließen. Ggf. wird die Stromstärke durch einen MPPT zu einem Maximum hin geregelt. Im Verlauf des Tages gegen Abend, oder allgemein bei Eintritt der Dunkelheit, nimmt der Betriebsstrom 8a allmählich ab bis er den Stromschwellwert erreicht bzw. unterschreitet. Das allmähliche, also langsame Abfallen des Messwertverlaufs 8, mathematisch genauer die geringe negative Steigung der Messwertfunktion 8, kann mittels der Auswerteeinrichtung 77 als Signal dafür interpretiert werden, dass ein gewöhnlicher Verlauf eines Sonnenuntergangs vorliegt, bei welchem die Sicherheitsschaltungen 13 nach und nach die jeweils zugeordneten intelligenten Solarmodule 30 abschalten. Andererseits kann auch das Unterschreiten des Stromschwellwerts als Signal verwendet werden. Werden Betriebsspannung 6a und Betriebsstrom 8a gemeinsam überprüft (Schritt 141), so lassen sich für die erste und zweite Messwertfunktion 6, 8 beispielsweise Parameter definieren, die erfüllt sein müssen, um eine gewöhnliche Anlagenabschaltung als "sicher" bzw. "unkritisch" zu erkennen.

Beispielsweise können Parameter der ersten Messwertfunktion 6 ein "Sprung" um -50% im Funktionswert an der Sprungstelle 9 sein. Mit anderen Worten liegt an einer Unstetigkeitsstelle 9 der Funktion mindestens eine Halbierung des Betrags des Funktionswerts der Messwertfunktion 6 in einem vordefinierten Zeitintervall 10, beispielsweise innerhalb von 5, 10 oder 15 Sekunden, vor. Ein weiterer Parameter der ersten Messwertfunktion kann ein Absolutbetragsänderung an der Sprungstelle 9 sein, beispielsweise eine Mindeständerung, genauer eine Mindestabsenkung, der Betriebsspannung 6a um 40 Volt innerhalb des Zeitintervalls 10. Noch ein weiterer Parameter für die erste Messwertfunktion kann das Erreichen eines Spannungsmindestwertes 134 sein, für den beispielsweise nach der Sprungstelle mehr als 20V verbleiben sollen. Bevorzugt sind alle drei genannten Parameter in Summe zu erfüllen.

Gleichzeitig zu den Parametern der ersten Messwertfunktion 6, also in demselben vordefinierten Zeitintervall 10, können von der zweiten Messwertfunktion 8 Parameter zu erfüllen sein, damit die Starterschaltung 71 eine "normale Abschaltung" identifiziert. Durch die gleichzeitige Erfassung und Auswertung der zweiten Messwertfunktion 8 wird die Sicherheit der Erkennung der Auswerteeinrichtung 77, und somit der gesamten Photovoltaikanlage 1, erhöht. Parameter der zweiten Messwertfunktion 8 kann sein, dass der Betriebsstrom 8a nach der Sprungstelle 9 unterhalb des Stromschwellwerts, also beispielsweise bei einem Wert von 0 ±5 mA, liegt.

Die Auswerteeinrichtung 77 kann allein anhand von Parametern, wie die zuvor beispielhaft und nicht abschließend aufgezählten, erkennen und unterscheiden, ob eine gewöhnliche Anlagenabschaltung 146a oder ein Fehlerfall 58c vorliegt. Es wird die Erkennungsrate von Störfällen erhöht und, was für den Betreiber einer Photovoltaikanlage 1 auch eine hohe Bedeutung hat, die fehlerhafte Erkennung von Störfällen weiter verringert, so dass die Photovoltaikanlage 1 auch eine größere Zeit zur Stromerzeugung zur Verfügung stehen kann. Die Länge des Zeitintervalls 10 kann einerseits derart gewählt werden, dass eine optimale Erkennung des Messwertverlaufs 6, 8 ermöglicht ist, so dass Falscherkennungen vermieden werden. Andererseits kann die Länge des Zeitintervalls 10 auch, wie bei Photovoltaiksystemen derzeit üblich, durch eine Norm festgelegt werden, so dass eine optimale Erkennung in vorgegebener Zeitdauer gewählt wird. Ein Zeitintervall 10 im Bereich bis 15 Sekunden ist dabei bevorzugt, da die Leistungsabgabe der Photovoltaikanlage 1 in dieser Zeitdauer überschaubar kurz und für handelsübliche elektrische Verbinder und Isolatoren beherrschbar ist. Eine Verkürzung des Zeitintervalls 10 erhöht die Anforderung an die Auswerteeinrichtung 77, Fehler sicher zu erkennen. Eine Verlängerung des Zeitintervalls 10 erhöht dagegen die Anforderungen an die übrigen elektrischen Komponenten, einen Störfall länger "auszuhalten".

Gegebenenfalls kann die Starterschaltung 71 die in Fig. 13 gezeigte sicher erkannte Abschaltung der intelligenten Solarmodule 30 in dem Zustandsspeicher 60 als Einnahme des Sicherheitszustands 58b speichern, so dass die Starterschaltung 71 bei der nächsten Inbetriebnahme, beispielsweise am nächsten Morgen, das sichere Abschalten der Photovoltaikanlage 13 des Vortages kennt. Diese Information kann auch für weitere Auswertungszwecke beispielsweise über die Schnittstelle 84 bereitgestellt werden. Prinzipiell kann die Starterschaltung aber auch mit den zwei Zuständen Betriebszustand 58a und Fehlerzustand 58c auskommen, um eine sichere Separation von Störfällen zu erlauben.

Ein weiteres Beispiel von zu erkennenden ersten und zweiten Messwertverläufen 6, 8 zeigt Figur 14. Im oberen Teil der Figur ist ein zeitlicher Spannungsverlauf gezeigt. Bis zum Erreichen der Betriebsspannung 6a und dem Einstellen der Betriebsspannung anhand des MPPT entspricht der Verlauf demjenigen der Fig. 13. Nun ist aber zu Beginn eines Zeitintervalls 10, beispielsweise innerhalb von 5, 10 oder 15 Sekunden, eine erste Sprungstelle 9a zu erkennen, an der der Messwertverlauf 6 sprunghaft ansteigt, beispielsweise auf eine Leerlaufspannung. Innerhalb des Zeitintervalls 10 sinkt der Absolutwert schließlich um einen hohen Betrag auf den Spannungsmindestwert 134.

Der im unteren Teil der Fig. 14 gezeigte zweite Messwertverlauf 8 stellt abermals einen Stromverlauf dar, welcher dem in Fig. 13 bis zum Erreichen des Betriebsstroms 8a gezeigten gleicht. Der gezeigte Verlauf von Spannung und Strom in dem Strang 20 der Photovoltaikanlage 1 zeigt beispielhaft die Trennung des Wechselrichters 90 vom Stromnetz der Photovoltaikanlage 1, wobei die Sicherheitsschaltungen 13 die intelligenten Solarmodule 30 noch nicht in den Sicherheitszustand geschaltet haben. Beim Trennen des Wechselrichters 90 an der ersten Sprungstelle 9a stehen die Solarmodule 30 nicht mehr "unter Last", so dass die Spannung zunächst auf die Leerlaufspannung sprunghaft ansteigt. An der zweiten Sprungstelle 9b kann die Solaranlage schließlich sicher abgeschaltet werden, indem die Solarmodule 30 mittels der Sicherheitsschaltung in den Sicherheitszustand 58b gebracht werden.

Als ein erster Parameter zum Erkennen der gezeigten Wechselrichtertrennung wird eine Spannungsänderung im ersten Messwertverlauf 6 an der ersten Sprungstelle 9a um etwa bzw. mindestens +10% identifiziert. Mit anderen Worten steigt an einer ersten Unstetigkeitsstelle 9a innerhalb eines vordefinierten Zeitintervalls 10 der erste Messwertverlauf um zumindest 1/10 des Absolutbetrages. Innerhalb des vordefinierten Zeitintervalls 10, beispielsweise von 10 oder 15 Sekunden, liegt mindestens eine Halbierung des Betrags des Funktionswerts des ersten Messwertverlaufs 6 an einer zweiten Sprungstelle 9b der Funktion vor. Weiterer möglicher Parameter der ersten Messwertfunktion ist eine Absolutbetragsänderung der Betriebsspannung 6a an der Sprungstelle 9b um 40 Volt oder mehr innerhalb desselben vordefinierten Zeitintervalls 10. Noch ein weiterer möglicher Parameter für die erste Messwertfunktion 6 ist in dem Ausführungsbeispiel der Fig. 14 das Erreichen eines bzw. das Absinken auf einen Spannungsmindestwert 134, beispielsweise 30 Volt, oder auf mindestens 20 Volt als Absolutwert.

Ein möglicher Parameter der zweiten Messwertfunktion 8 ist an der ersten Sprungstelle 9a ein Absolutwert des Betriebsstromes 8a von weniger als 150 mA. Mit anderen Worten kann ein Parameter der zweiten Messwertfunktion 8 sein, dass der gemessene Betriebsstrom 8a unterhalb des vordefinierten Stromschwellwertes liegt. An der ersten Sprungstelle 9a springt zeitgleich, oder näherungsweise zeitgleich (abhängig u.A. von der Messauflösung, z.B. der "sampling rate", des eingesetzten Messsystems) zu der Änderung der ersten Messwertfunktion 6 die zweite Messwertfunktion 8 auf einen sehr kleinen Wert, beispielsweise vereinfachend auf 0 ±5 mA.

Anhand der genannten Parameter lässt sich im Ausführungsfall der Fig. 14 eine Abschaltung des Wechselrichters 90 mit erhöhter Sicherheit erkennen und von einem Störfall separieren.

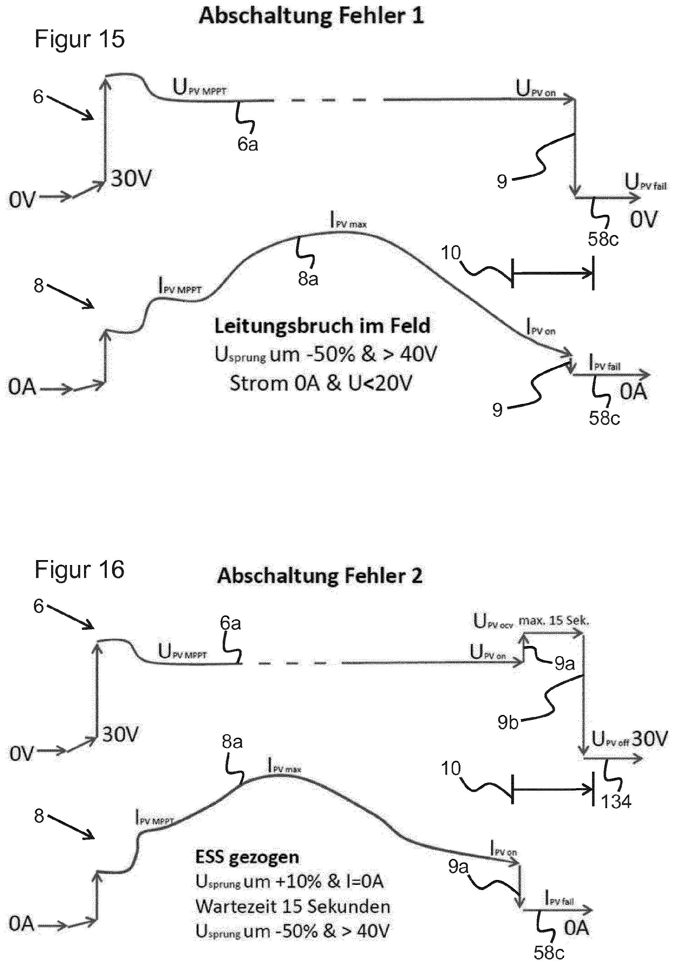

Figur 15 zeigt die Erkennung eines ersten Störfalles. Der in der Fig. 15 oben dargestellte erste Messwertverlauf 6 entspricht bis zum Erreichen der Betriebsspannung 6a dem der Fig. 13. An einer Unstetigkeitsstelle 9 der Messwertfunktion 6 liegt mindestens eine Halbierung des Betrags des Funktionswerts der Messwertfunktion 6 in einem vordefinierten Zeitintervall 10, beispielsweise innerhalb von 10 oder 15 Sekunden, vor. Ein weiterer Parameter der ersten Messwertfunktion ist eine hohe Absolutbetragsänderung der Betriebsspannung 6a an der Sprungstelle 9 um mindestens 40 Volt innerhalb des vordefinierten Zeitintervalls 10. Noch ein weiterer Parameter für die erste Messwertfunktion 6 ist das Absinken des Absolutwertes der ersten Messwertfunktion 6 unter den Spannungsmindestwert 134 innerhalb des vordefinierten Zeitintervalls 10, also insbesondere nach der Sprungstelle weniger als 20V.

Die in Fig. 15 im unteren Teil gezeigte zweite Messwertfunktion 8, abermals ein Stromverlauf, ist bis zum Erreichen des Betriebsstroms 8a wie in Fig. 13. An der Sprungstelle 9 innerhalb des vordefinierten Zeitintervalls 10 sinkt die Stromstärke auf einen Absolutwert unterhalb des Stromschwellwerts, also beispielsweise auf 0 ±5 mA.

In dem Beispiel der Fig. 15 liegt ein Fehlerfall vor, bei dem es sich beispielsweise um einen Leitungsbruch im Anlagenfeld, allgemein einen Kurzschluss, handelt. Der im Normalfall von der Stromquelle 82 auf Spannungsmindestwert 134 gehaltene Spannungswert sinkt unter den Spannungsmindestwert 134, was als Parameter für einen Kurzschluss erkannt wird. In dem Zustandsspeicher 60 wird der Anlagenzustand Fehlerzustand 58c gesetzt. Nun verbleibt die Anlage im abgeschalteten, also im Wesentlichen spannungsfreien Zustand und geht nicht autark wieder in Betrieb, da davon auszugehen ist, dass die Ursache des Störfalles zunächst zu beseitigen ist. Ggf. kann somit nach dem Auftreten eines Störfalls und dem Setzen des Fehlerzustands 58c ein Eingreifen von Bedienpersonal erforderlich gemacht werden. Das Eingreifen von Bedienpersonal, also Fachleuten, zum Wiederanschalten der Anlage nach einem Störfall kann die Sicherheit des Anlagenbetriebs weiter erhöhen, da nun von geschultem Personal die Anlage zunächst geprüft werden kann, bevor diese wieder an das Netz angeschaltet wird. Unter Umständen kann dieses Eingreifen von Bedienpersonal nach einem Störfall ebenfalls gefordert sein oder gefordert werden, so dass die hier vorgestellte Starterschaltung 71 mit Fehlerfallidentifizierung auch bei einer solchen ggf. von einer Norm oder einem Gesetz vorgeschriebenen Inbetriebnahme durch geschultes Personal die erforderlichen Maßnahmen bereitstellt, ein unautorisiertes Anschalten der Photovoltaikanlage 1 zu verhindern.

In Figur 16 ist ein weiterer Fehlerfall gezeigt. Der im oberen Teil der Figur gezeigte erste Messwertverlauf 6 ist abermals bis zum Erreichen der Betriebsspannung 6a identisch zu Fig. 13. In einem vordefinierten Zeitintervall 10 steigt nun an einer ersten Sprungstelle 9a der Absolutwert der Messwertfunktion 6 beispielsweise um 1/10 des Absolutbetrags oder mehr insbesondere auf die Leerlaufspannung an, verbleibt über einen kurzen Zeitraum erhöht, in diesem Beispiel über 9 Sekunden, und sinkt innerhalb des vordefinierten Zeitintervalls 10 schließlich an der zweiten Sprungstelle 9b um mindestens die Hälfte, zugleich um mindestens 40 Volt des Absolutwertes. Mit anderen Worten wird der Funktionswert an der zweiten Sprungstelle 9b zumindest halbiert. Zugleich sinkt der zweite Funktionsverlauf 8 (der bis zum Erreichen der Betriebsstroms 8a dem der Fig. 13 entspricht) innerhalb des vordefinierten Zeitintervalls 10 an der ersten Sprungstelle 9a unterhalb des Stromschwellwertes, also beispielsweise auf 0 ±5 mA. Der in Fig. 16 exemplarisch gezeigte Fehlerfall entspricht dem zu beobachtenden Messwertverläufen beispielsweise bei einem Leitungsbruch in einem Bereich vor dem Wechselrichter 90 aber nach den Solarmodulen 30, Der in Fig. 16 gezeigte Fehlerfall entspricht aber auch dem Fall, dass der ESS (Electronic Solar Switch) z.B. von der Feuerwehr betätigt wird. Auch dies ist kein gewöhnlicher Betrieb, sondern als Fehlerfall zu behandeln.

Figur 17 zeigt ein Beispiel eines Startsignals bzw. Startimpulses 148. In Zeitabständen von 1000 ms werden Strompulse 148 einer Höhe von mind. 100 mA und einer Zeitdauer von etwa 500 ms auf die Strangleitung gegeben. Dieses Signal kann beispielsweise als Startsignal bzw. Startstrom im Betriebszustand 58a der Anlage dauerhaft in die leistungsführende Strangleitung eingeprägt werden, so dass die Sicherheitsschaltungen 13 nur dann das zugeordnete Solarmodul 30 Leistung abgeben lassen, wenn das Startsignal bzw. der Startstrom vorhanden ist. Andererseits kann das in Fig. 17 gezeigte Signal auch dazu verwendet werden, die Photovoltaikanlage 1 nach einem Störfall wieder zum normalen Betrieb freizugeben, indem es das Setzen des Betriebszustandes 58a in den Zustandsspeicher 20 bewirkt.

In vorteilhafter Weise kann die Messeinrichtung durch das vorbeschriebene Verfahren vereinfacht aufgebaut werden dahingehend, dass eine Spannungsmessung in einem im Vergleich zur Betriebsspannung 6a kleinen Bereich ausreichen kann, beispielsweise im Bereich von 0 bis 120 Volt oder bis 130 Volt bei einer Betriebsspannung 6a im Bereich von 1000 Volt. Der zu erfassende Messbereich für die Spannung erfasst bevorzugt die Mindestbetriebsspannung der eingesetzten Wechselrichter, wobei die Mindestbetriebsspannung typischerweise bei 120 Volt liegt. Die Fehlererkennung, also damit die Wahl der Parameter, kann dabei noch weiter auf einen Bereich zwischen 0 bis 40 Volt verkleinert werden. Zugleich wird nur eine Strommessung in einem kleinen Bereich benötigt, die deutlich kleiner als der Betriebsstrom 8a ist, beispielsweise 0 bis 50 mA.

Zusammenfassend wird eine Erfindung vorgestellt, welche ein Fehlererkennungssystem in einer Photovoltaikanlage 1 bereitstellt, welches anhand eines ersten und ggf. zweiten Messwertverlaufs 6, 8 den Anlagenzustand zu erfassen vermag und somit Störfälle vom Betriebszustand der Anlage zu unterscheiden vermag. Dies kann den Ertrag der Anlage weiter erhöhen.

Es ist dem Fachmann ersichtlich, dass die vorstehend beschriebenen Ausführungsformen beispielhaft zu verstehen sind, und die Erfindung nicht auf diese beschränkt ist, sondern in vielfältiger Weise variiert werden kann, ohne den Schutzbereich der Ansprüche zu verlassen.

### Bezugszeichenliste:

- 1: Photovoltaikanlage
- 6: Erster Messwertverlauf
- 6a: Betriebsspannung
- 8: Zweiter Messwertverlauf
- 8a: Betriebsstrom
- 9: Sprungstelle
- 10: Zeitintervall
- 12: Solaranschlussdose
- 12a: Konventionelle Solaranschlussdose
- 13: Sicherheitsschaltung
- 14: Anschlussdosengehäuse
- 14a-d: Seitenwand des Anschlussdosengehäuses
- 14e: Deckel
- 14f: Unterseite
- 14g: Rand
- 16: Kabeldurchführung
- 18: Strangleitung
- 20: Strang
- 22: Anschlusselemente
- 24: Zwischenabgriff
- 30: Solarmodul
- 30a: nicht-intelligentes Solarmodul
- 32: Solar-Teilmodul
- 34: Bypass-Diode
- 36: Spannungssensor
- 36a: Verbindung
- 40: Mikrocontroller
- 42: Energieversorgungseinrichtung
- 42a: Versorgungsleitung
- 51: Freischalter
- 52: Kurzschlussschalter
- 53: Nebenschlussschalter
- 54: Freischalter
- 55: Aktivierungsschalter
- 58: Anlagenzustand
- 58a: Betriebszustand
- 58b: Sicherheitszustand
- 58c: Fehlerzustand
- 60: Zustandsspeicher
- 62: Anschlusselemente
- 66: Spannungssensor
- 66a: Verbindung
- 68: Stromsensor
- 68a: Verbindung
- 70: Startbox
- 71: Starterschaltung
- 72: Eingangsanschluss
- 73: Ausgangsanschluss
- 74: Spannungssensor
- 74a: Verbindung
- 75: Messeinrichtung
- 76: Stromsensor
- 76a: Verbindung
- 77: Auswerteeinrichtung
- 78: Einstrahlungssensor
- 78a: Verbindung
- 79: Zeitsteuerung
- 80: Controller
- 81: Kapazität
- 82: Stromquelle
- 82a: Diode
- 83a: Netzteil
- 83b: Netzteil
- 84: Schnittstelle
- 85: Energieversorgung
- 85a: Diode
- 86,88: Signaleinrichtung
- 90: Wechselrichter
- 91: Stromkreis
- 92: Eingangskapazität
- 102: Schritt des Verfahrens "Power-Up"
- 104: Schritt des Verfahrens "Startschritt"
- 106: Schritt des Verfahrens
- 108: Schritt des Verfahrens
- 110: Schritt des Verfahrens "Prüfschritt"
- 111: Regelkreis (Sicherheitszustand)
- 114: Betriebsmodus
- 116: Schritt des Verfahrens "Prüfschritt"
- 117: Regelkreis
- 132: Erster Verfahrensschritt
- 134: Spannungsmindestwert
- 136: Start der Starterschaltung
- 138: Messwerterfassung
- 140: Regelschleife
- 141: Überprüfungsschritt
- 142: Entscheidungsschritt
- 142a: unkritischer Messwertverlauf
- 142b: kritischer Messwertverlauf
- 144: Auslesen des Zustandsspeichers
- 146a: Zustandsüberprüfung ok
- 146c: Zustandsüberpüfung nicht ok
- 148: Abgabe Startsignal
- 149: Schreiben des Zustandsspeichers

## Patentansprüche

1. Verfahren zum Erkennen einer elektrischen Störung in einer Photovoltaikanlage (1) mit den Schritten
- Messen (138) zumindest eines ersten Messwertverlaufs (6) einer ersten elektrischen Kenngröße in der Photovoltaikanlage, insbesondere eines Stranges (20) der Photovoltaikanlage,
- Überprüfen (141) des ersten Messwertverlaufs,
- Erkennen eines Anlagenzustands (58, 58a, 58b, 58c, 111, 117) anhand des ersten Messwertverlaufs,
- Speichern (149) des Anlagenzustands in einen Zustandsspeicher (60),
- Auslesen (144) des Anlagenzustands aus dem Zustandsspeicher,
- in Ansprechen auf den Anlagenzustand Ausgeben (148) eines Freigabesignals an jeweilige Solarmodule der Photovoltaikanlage,
- Erkennen des Freigabesignals oder das Fehlen des Freigabesignals durch das jeweilige Solarmodul.

2. Verfahren nach einem der vorstehenden Ansprüche, ferner mit den zusätzlichen Schritten:
- Messen (138) eines zweiten Messwertverlaufs (8) einer zweiten elektrischen Kenngröße der Photovoltaikanlage (1), insbesondere des Stranges (20) der Photovoltaikanlage,
- synchrones Überprüfen (141) des ersten (6) und zweiten Messwertverlaufs und
- Erkennen des Anlagenzustands (58, 58a, 58b, 58c, 111, 117) anhand einer Verknüpfung der Überprüfungsergebnisse des ersten und zweiten Messwertverlaufs.

3. Verfahren nach einem der vorstehenden Ansprüche,
wobei die Photovoltaikanlage (1) zumindest einen Wechselrichter (90) aufweist zum Herstellen einer Wechselspannung aus der Photovoltaikanlagengleichspannung und
wobei das Überprüfen (141) des Messwertverlaufs (6, 8) unterhalb einer Mindestbetriebsspannung des Wechselrichters durchgeführt wird.

4. Photovoltaikanlage (1) mit zumindest einem Strang (20) aus seriell zusammengeschalteten Solarmodulen (30, 30a) zum Erzeugen von elektrischer Leistung aus Sonnenenergie, umfassend:
eine Mehrzahl von Solarmodulen, welche jeweils eine Solaranschlussdose (12) umfassen,
eine Messeinrichtung (75) zum Messen eines ersten Messwertverlaufs (6) einer ersten elektrischen Kenngröße in der Photovoltaikanlage, insbesondere des Stranges,
eine Auswerteeinrichtung (77) zum Überprüfen (141) des ersten Messwertverlaufs und zum Erkennen eines Anlagenzustands (58, 58a, 58b, 58c, 111, 117) anhand des ersten Messwertverlaufs,
einen Zustandsspeicher (60) zum Speichern (149) des Anlagenzustands,
eine an eine Strangleitung (18) angeschlossene Starterschaltung (71), welche den Zustandsspeicher enthaltend den Anlagenzustand ausliest und welche dazu ausgebildet ist, in Ansprechen auf den Anlagenzustand einen Startstrom oder ein Startsignal in die Strangleitung einzuprägen (148), wobei die Solarmodule hergerichtet sind, den Startstrom oder das Startsignal oder das Ausbleiben des Startstroms oder des Startsignals zu erkennen.

5. Photovoltaikanlage (1) nach Anspruch 4, wobei der Zustandsspeicher (60) ein Flash-Speicher ist, der auch bei Ausfall der Energieversorgung den abgespeicherten Anlagenzustand (58, 58a, 58b, 58c, 111, 117) behält und/oder
wobei der Zustandsspeicher (60) einen Schreibschutz aufweist, so dass der Zustandsspeicher nicht mehr beschrieben werden kann, und der Schreibschutz automatisch aktiviert wird, sobald ein Fehlerzustand (58c, 117) des Anlagenzustands im Zustandsspeicher gespeichert ist.

6. Photovoltaikanlage (1) nach einem der Ansprüche 4-5, wobei die Auswerteeinrichtung (77) einen Mikrocontroller aufweist und/oder
wobei die Auswerteeinrichtung (77) in Ansprechen auf einen Spannungssensor (36, 66) und/oder einen Stromsensor (68) den Anlagenzustand (58, 58a, 58b, 58c, 111, 117) erkennt und den Anlagenzustand in dem Zustandsspeicher (60) speichert (149).

7. Photovoltaikanlage (1) nach vorstehendem Anspruch,
wobei der Mikrocontroller einen Vergleichsspeicher umfasst,
wobei in dem Vergleichsspeicher vordefinierte Messwertverläufe (6, 8) für den Betriebszustand (58a) und den Fehlerzustand (58c, 117) hinterlegt sind, und
wobei der Mikrocontroller die gemessenen Messwertverläufe mit den vordefinierten Messwertverläufen vergleicht und den Anlagenzustand (58, 58a, 58b, 58c, 111, 117) erkennt.

8. Photovoltaikanlage (1) nach einem der Ansprüche 4-7, wobei zumindest eines der Solarmodule (30) eine Sicherheitsschaltung (13) aufweist, die in Ansprechen auf den Startstrom oder das Startsignal (148) das Abführen des von dem Solarmodul erzeugten Solarstroms durch die Solaranschlussdose (12) über die Strangleitung (18) freigibt, oder die in Ansprechen auf das Fehlen des in die Strangleitung (18) eingeprägten Startstrom oder des Startsignals (148) das Solarmodul (30) von der Photovoltaikanlage freischaltet.

9. Photovoltaikanlage (1) nach einem der Ansprüche 4-8, wobei die Messeinrichtung (75) und die Auswertungseinrichtung (77) Teil der Starterschaltung (71) sind und die Starterschaltung in einer separat von den Solarmodulen (30) an den Strang (20) angeschlossenen Startbox (70) angeordnet ist.

10. Photovoltaikanlage (1) nach Anspruch 8 oder 9, wobei die Sicherheitsschaltung (13) in einem Sicherheitszustand (58b, 111) der Photovoltaikanlage oder in dem Fehlerzustand (58c, 117) der Photovoltaikanlage von dem zugehörigen Solarmodul (30) mit elektrischer Leistung versorgt wird, wenn das zugehörige Solarmodul von Licht beschienen wird, damit die Sicherheitsschaltung von dem Sicherheitszustand oder von dem Fehlerzustand in den Betriebszustand (58a) umschalten kann.

11. Photovoltaikanlage (1) nach einem der Ansprüche 4-10, wobei der erste Messwertverlauf (6) ein Spannungsverlauf ist, und
wobei die Auswerteeinrichtung (77) eine Stromquelle (82), insbesondere ein nicht-intelligentes Solarmodul (30a) oder ein Netzgerät (83a, 83b), umfasst, um den Spannungsverlauf auf einen Mindestwert größer als Null anzuheben.

12. Photovoltaikanlage (1) nach einem der Ansprüche 4-11, wobei die Sicherheitsschaltung (13) einen Stromsensor (68) aufweist, welcher den von der Starterschaltung (71) in die Strangleitung (18) eingeprägten Startstrom (148) misst oder detektiert, um in Ansprechen auf das Messergebnis die Sicherheitsschaltung von dem Sicherheitszustand (58b, 111) oder dem Fehlerzustand (58c, 117) automatisch in den Betriebszustand (58a) umzuschalten und umgekehrt.

13. Photovoltaikanlage (1) nach einem der Ansprüche 4-12, wobei die Sicherheitsschaltung (13) derart ausgebildet ist, dass sie bei Abschattung des zugehörigen Solarmoduls (30) oder bei allgemeiner Dunkelheit und dem damit verbundenen Abfall der Modulspannung automatisch von dem Betriebszustand (58a) in den Sicherheitszustand (58b, 111) schaltet und/oder
wobei die Auswerteeinrichtung (77) derart ausgebildet ist, dass sie bei Unterschreiten einer Mindestbetriebsspannung des Wechselrichters (90), und damit dem regulären Abschalten des Wechselrichters bei großflächiger Abschattung oder allgemeiner Dunkelheit, automatisch von dem Betriebszustand (58a) in den Sicherheitszustand (58b, 111) schaltet, so dass kein Startstrom oder Startsignal (148) mehr an die Solarmodule (30) geschickt wird.

14. Photovoltaikanlage (1) nach einem der Ansprüche 4-13, wobei die Starterschaltung (71) einen Controller (80) mit einer Schnittstelle (84) und/oder einem externen Aktivierungsschalter (55) umfasst und der Controller (80) in Ansprechen auf ein Aktivierungssignal an der Schnittstelle (84) und/oder in Ansprechen auf die Betätigung des Aktivierungsschalters (55) und/oder in Ansprechen auf das Signal eines Einstrahlungssensors (78) und/oder in Ansprechen auf eine Zeitsteuerung das Einprägen des Startstroms oder Startsignals (148) in die Strangleitung (18) steuert.

15. Startbox (70) mit einer Starterschaltung (71) ausgebildet zum Anschließen an die Strangleitung (18) einer Photovoltaikanlage (1) gemäß einem der Ansprüche 4-14, und zum Einprägen des Startstroms oder Startsignals (148) in die Strangleitung in Ansprechen auf den in dem Zustandsspeicher gespeicherten Anlagenzustand (58, 58a, 58b, 58c, 111, 117), um das Umschalten der Sicherheitsschaltung (13) vom Sicherheitszustand (58b, 111) in den Betriebszustand (58a) oder den Fehlerzustand (58c, 117) zu bewirken und um das Schreiben (149) des Anlagenzustands in den Zustandsspeicher (60) zu bewirken.

## Claims

1. A method for detecting an electrical fault in a photovoltaic system (1), comprising the steps of:
- measuring (138) at least a first parameter profile of a first electrical parameter in the photovoltaic system (1), in particular in a string (20) of the photovoltaic system (1);
- evaluating (141) the first parameter profile;
- identifying a system state (58, 58a, 58b, 58c, 111, 117) based on the first parameter profile;
- storing (149) the system state in a state memory;
- retrieving (144) the system state from the state memory;
- in response to the system state, issuing (148) an enable signal to respective solar modules of the photovoltaic system;
- detecting the enable signal or the absence of the enable signal, by the respective solar module.

2. The method according to any one of the preceding claims, further comprising the additional steps of:
- measuring (138) a second parameter profile (8) of a second electrical parameter of the photovoltaic system (1), in particular of the string (20) of the photovoltaic system;
- synchronously evaluating (141) the first (6) and second parameter profiles; and
- identifying the system state (58, 58a, 58b, 58c, 111, 117) based on a combination of the evaluation results of the first and second parameter profiles.

3. The method according to any one of the preceding claims,
wherein the photovoltaic system (1) comprises at least one inverter (90) for producing an AC voltage from the DC voltage of the photovoltaic system; and
wherein the evaluating (141) of the parameter profiles (6, 8) is performed below a minimum operating voltage of the inverter.

4. A photovoltaic system (1) comprising at least one string (20) of series-connected solar modules (30, 30a) for generating electric power from solar energy, comprising:
a plurality of solar modules each comprising a solar junction box (12);
a measuring device (75) for measuring a first parameter profile (6) of a first electrical parameter in the photovoltaic system, in particular in said string;
evaluation means (77) for evaluating (141) the first parameter profile and for identifying a system state (58, 58a, 58b, 58c, 111, 117) based on the first parameter profile;
a state memory (60) for storing (149) the system state;
a starter circuit (71) connected to a string line (18), which reads out the state memory holding the system state and which is adapted to be responsive to the system state by injecting (148) a starting current or a start signal into the string line;
wherein the solar modules are adapted to detect the starting current or the start signal or the absence of the starting current or the start signal.

5. The photovoltaic system (1) according to claim 4,
wherein the state memory (60) is a flash memory which retains the stored system state (58, 58a, 58b, 58c, 111, 117) even in the event of a power supply failure; and/or
wherein the state memory (60) comprises a write protection so that the state memory can no longer be written, which write protection is automatically activated as soon as an error state (58c, 117) of the system state is stored in the state memory.

6. The photovoltaic system (1) according to any one of claims 4 to 5,
wherein the evaluation means (77) comprises a microcontroller; and/or
wherein the evaluation means (77) is responsive to a voltage sensor (36, 66) and/or a current sensor (68) by identifying the system state (58, 58a, 58b, 58c, 111, 117) and storing (149) the system state in the state memory (60).

7. The photovoltaic system (1) according to the preceding claim,
wherein the microcontroller comprises a comparison memory;
wherein the comparison memory holds predefined parameter profiles (6, 8) for the operating state (58a) and the error state (58c, 117); and
wherein the microcontroller compares the measured parameter profiles with the predefined parameter profiles to identify the system state (58, 58a, 58b, 58c, 111, 117).

8. The photovoltaic system (1) according to any one of claims 4 to 7,
wherein at least one of the solar modules (30) has a safety circuit (13) that is responsive to the starting current or start signal (148) to enable the solar module to feed generated solar power through the solar junction box (12) via a string line (18) or is responsive to the absence of the starting current or start signal (148) injected into the string line (18) by disconnecting the solar module (30) from the photovoltaic system.

9. The photovoltaic system (1) according to any one of claims 4 to 8, wherein the measuring device (75) and the evaluation means (77) are part of the starter circuit (71) and the starter circuit is accommodated in a start box (70) connected to the string (20) separately from the solar modules (30).

10. The photovoltaic system (1) according to claim 8 or 9, wherein in a safe state (58b, 111) of the photovoltaic system or in the error state (58c, 117) of the photovoltaic system the safety circuit (13) is powered by the associated solar module (30) when the associated solar module is irradiated by light, so that the safety circuit is able to switch from the safe state or the error state to the operating state (58a).

11. The photovoltaic system (1) according to any one of claims 4 to 10,
wherein the first parameter profile (6) is a voltage profile; and
wherein the evaluation means (77) comprises a power source (82), in particular a non-smart solar module (30a) or a power supply unit (83a, 83b) for raising the voltage profile to a minimum value greater than zero.

12. The photovoltaic system (1) according to any one of claims 4 to 11, wherein the safety circuit (13) comprises a current sensor (68) which measures or detects the starting current (148) injected into the string line (18) by the starter circuit (71) in order to automatically switch the safety circuit from the safe state (58b, 111) or the error state (58c, 117) to the operating state (58a), and vice versa, in response to the measurement result.

13. The photovoltaic system (1) according to any one of claims 4 to 12,
wherein the safety circuit (13) is adapted to automatically switch from the operating state (58a) to the safe state (58b, 111) when the associated solar module (30) is shadowed or in case of general darkness and the associated drop of module voltage; and/or
wherein the evaluation means (77) is adapted to automatically switch from the operating state (58a) to the safe state (58b, 111) when the voltage falls below a minimum operating voltage of the inverter (90) so causing a normal shutdown of the inverter in the case a large area is shadowed or in the case of general darkness, so that no starting current or start signal (148) is transmitted to the solar modules (30) any longer.

14. The photovoltaic system (1) according to any one of claims 4 to 13, wherein the starter circuit (71) comprises a controller (80) having an interface (84) and/or an external enable switch (55), and wherein the controller (80) is responsive to an activation signal at the interface (84) and/or is responsive to an actuation of the enable switch (55) and/or is responsive to a signal of an irradiation sensor (78) and/or is responsive to a timer by controlling the injection of the starting current or start signal (148) into the string line (18).

15. A start box (70), comprising a starter circuit (71) adapted for being connected to the string line (18) of a photovoltaic system (1) according to any one of claims 4 to 14 and for injecting the starting current or start signal (148) into the string line in response to the system state (58, 58a, 58b, 58c, 111, 117) stored in the state memory to cause the safety circuit (13) to switch from the safe state (58b, 111) to the operating state (58a) or to the error state (58c, 117) and to cause the system state to be written (149) into the state memory (60).

## Revendications

1. Procédé de détection d'une défaillance électrique dans une installation photovoltaïque (1), comprenant les étapes suivantes :
- mesure (138) d'au moins une première variation de valeur mesurée (6) d'une première caractéristique électrique dans l'installation photovoltaïque, en particulier d'une chaîne (20) de l'installation photovoltaïque,
- vérification (141) de la première variation de valeur mesurée,
- identification d'un état de l'installation (58, 58a, 58b, 58c, 111, 117) à l'aide de la première variation de valeur mesurée,
- enregistrement (149) de l'état de l'installation dans une mémoire d'état (60),
- lecture (144) de l'état de l'installation dans la mémoire d'état,
- en réponse à l'état de l'installation, émission (148) d'un signal de validation à destination de modules solaires respectifs de l'installation photovoltaïque,
- détection du signal de validation ou de l'absence du signal de validation, par le module solaire respectif.

2. Procédé selon l'une des revendications précédentes, comprenant en outre les étapes suivantes :
- mesure (138) d'une deuxième variation de valeur mesurée (8) d'une deuxième caractéristique électrique de l'installation photovoltaïque (1), en particulier de la chaîne (20) de l'installation photovoltaïque,
- vérification synchrone (141) de la première (6) et de la deuxième variation de valeur mesurée, et
- identification de l'état de l'installation (58, 58a, 58b, 58c, 111, 117) à l'aide d'une combinaison des résultats de vérification de la première et de la deuxième variation de valeur mesurée.

3. Procédé selon l'une des revendications précédentes,
selon lequel l'installation photovoltaïque (1) présente au moins un onduleur (90) destiné à générer une tension alternative à partir de la tension continue de l'installation photovoltaïque, et
selon lequel la vérification (141) de la variation de valeur mesurée (6, 8) est effectuée en dessous d'une tension de fonctionnement minimale de l'onduleur,

4. Installation photovoltaïque (1) comprenant au moins une chaîne (20) de modules solaires (30, 30a) branchés en série, en vue de la génération de puissance électrique à partir de l'énergie solaire, comportant :
une pluralité de modules solaires qui comportent chacun une boîte de jonction solaire (12),
un dispositif de mesure (75) destiné à mesurer une première variation de valeur mesurée (6) d'une première caractéristique électrique dans l'installation photovoltaïque, en particulier de la chaîne,
un dispositif d'évaluation (77) destiné à vérifier (141) la première variation de valeur mesurée et à identifier un état de l'installation (58, 58a, 58b, 58c, 111, 112) à l'aide de la première variation de valeur mesurée,
une mémoire d'état (60) destinée à l'enregistrement (149) de l'état de l'installation,
un circuit de démarrage (71) qui est connecté à une ligne de chaîne (18) et qui effectue la lecture de la mémoire d'état contenant l'état de l'installation et qui est conçu pour appliquer (148) un courant de démarrage ou un signal de démarrage à la ligne de chaîne, en réponse à l'état de l'installation, les modules solaires étant conçus pour détecter le courant de démarrage ou le signal de démarrage ou l'absence du courant de démarrage ou du signal de démarrage.

5. Installation photovoltaïque (1) selon la revendication 4,
dans laquelle la mémoire d'état (60) est une mémoire flash qui conserve l'état de l'installation (58, 58a, 58b, 58c, 111, 117) enregistré, même en cas de défaillance de l'alimentation en énergie, et/ou
dans laquelle la mémoire d'état (60) présente une protection en écriture, de sorte que la mémoire d'état ne peut plus recevoir d'écriture, et la protection en écriture est activée automatiquement dès qu'un état de défaut (58c, 117) de l'état de l'installation est enregistré dans la mémoire d'état.

6. Installation photovoltaïque (1) selon l'une des revendications 4 à 5,
dans laquelle le dispositif d'évaluation (77) présente un microcontrôleur et/ou
dans laquelle le dispositif d'évaluation (77) détecte l'état de l'installation (58, 58a, 58b, 58c, 111, 117), en réponse à un capteur de tension (36, 66) et/ou un capteur de courant (68), et enregistre (149) l'état de l'installation dans la mémoire d'état (60).

7. Installation photovoltaïque (1) selon la revendication précédente,
dans laquelle le microcontrôleur comprend une mémoire de comparaison,
dans laquelle des variations de valeur mesurée (6, 8) prédéfinies pour l'état de fonctionnement (58a) et l'état de défaut (58c, 117) sont enregistrées dans la mémoire de comparaison, et
dans laquelle le microcontrôleur compare les variations mesurées des valeurs de mesure avec les variations de valeur mesurée prédéfinies et identifie l'état de l'installation (58, 58a, 58b, 58c, 111, 117).

8. Installation photovoltaïque (1) selon l'une des revendications 4 à 7,
dans laquelle au moins un des modules solaires (30) présente un circuit de sécurité (13) qui, en réponse au courant de démarrage ou au signal de démarrage (148), autorise la transmission du courant solaire généré par le module solaire, par la boîte de jonction solaire (12), via la ligne de chaîne (18), ou bien qui, en réponse à l'absence du courant de démarrage injecté dans la Signe de chaîne (18) ou du signal de démarrage (148), déconnecte le module solaire (30) de l'installation photovoltaïque.

9. Installation photovoltaïque (1) selon l'une des revendications 4 à 8,
dans laquelle le dispositif de mesure (75) et le dispositif d'évaluation (77) font partie du circuit de démarrage (71), et le circuit de démarrage est installé dans une boîte de démarrage (70) qui est connectée à la chaîne (20) séparément des modules solaires (30).

10. Installation photovoltaïque (1) selon la revendication 8 ou 9,
dans laquelle, en cas d'état de sécurité (58b, 111) de l'installation photovoltaïque ou en cas d'état de défaut (58c, 117) de l'installation photovoltaïque, le circuit de sécurité (13) est alimenté avec de la puissance électrique par le module solaire (30) associé, si le module solaire associé est éclairé avec de la lumière, pour que le circuit de sécurité puisse commuter de l'état de sécurité ou de l'état de défaut à l'état de fonctionnement (58a).

11. Installation photovoltaïque (1) selon l'une des revendications 4 à 10,
dans laquelle la première variation de valeur mesurée (6) est une variation de tension, et
dans laquelle le dispositif d'évaluation (77) comprend une source de courant (82), en particulier un module solaire non intelligent (30a) ou un bloc d'alimentation (83a, 83b), pour élever la tension à une valeur minimale supérieure à zéro.

12. Installation photovoltaïque (1) selon l'une des revendications 4 à 11,
dans laquelle le circuit de sécurité (13) présente un capteur de courant (68) qui mesure ou détecte le courant de démarrage (148) injecté par le circuit de démarrage (71) dans la ligne de chaîne (18), afin de commuter le circuit de sécurité de l'état de sécurité (58b, 111) ou de l'état de défaut (58c, 117) automatiquement à l'état de fonctionnement (58c) et inversement, en réponse au résultat de mesure.

13. Installation photovoltaïque (1) selon l'une des revendications 4 à 12,
dans laquelle le circuit de sécurité (13) est réalisé de manière telle que, en cas d'ombrage du module solaire (30) associé ou en cas d'obscurité générale et de chute de la tension de module qui l'accompagne, ledit circuit commute automatiquement de l'état de fonctionnement (58a) à l'état de sécurité (58b, 111), et/ou
dans laquelle le dispositif d'évaluation (77) est réalisé de manière telle que, en cas de passage en dessous d'une tension de fonctionnement minimale de l'onduleur (90), et donc d'arrêt normal de l'onduleur en cas d'ombrage sur une grande surface ou d'obscurité générale, ledit dispositif commute automatiquement de l'état de fonctionnement (58a) à l'état de sécurité (58b, 111), de sorte que plus aucun courant de démarrage ou signal de démarrage (148) ne soit transmis aux modules solaires (30).

14. installation photovoltaïque (1) selon l'une des revendications 4 à 13,
dans laquelle le circuit de démarrage (71) comprend un contrôleur (80) doté d'une interface (84) et/ou d'un interrupteur d'activation (55) externe, et le contrôleur (80), en réponse à un signal d'activation sur l'interface (84) et/ou en réponse à la manœuvre de l'interrupteur d'actionnement (55) et/ou en réponse au signal d'un capteur de rayonnement (78) et/ou en réponse à une synchronisation, commande l'injection du courant de démarrage ou du signal de démarrage (148) dans la ligne de chaîne (18).

15. Boîte de démarrage (70) comprenant un circuit de démarrage (71) agencé en vue d'une connexion à la ligne de chaîne (18) d'une installation photovoltaïque (1) selon l'une des revendications 4 à 14, et en vue de l'injection du courant de démarrage ou du signal de démarrage (148) dans la ligne de chaîne, en réponse à l'état de l'installation (58, 58a, 58b, 58c, 111, 117) enregistré dans la mémoire d'état, pour déclencher la commutation du circuit de sécurité (13) de l'état de sécurité (58b, 111) à l'état de fonctionnement (58a) ou à l'état de défaut (58c, 117) et pour déclencher l'inscription (149) de l'état de l'installation dans la mémoire d'état (60).
